(19) Europäisches Patentamt
European Patent Office
Office européen des brevets

(11) **EP 3 556 007 B1**

(12) **EUROPÄISCHE PATENTSCHRIFT**

(45) Veröffentlichungstag und Bekanntmachung des Hinweises auf die Patenterteilung:
**27.08.2025 Patentblatt 2025/35**

(21) Anmeldenummer: **17800493.3**

(22) Anmeldetag: **14.11.2017**

(51) Internationale Patentklassifikation (IPC):
**H02N 15/00** (2006.01)   **B60L 13/06** (2006.01)
**H01L 21/677** (2006.01)

(52) Gemeinsame Patentklassifikation (CPC):
**H02N 15/00; B60L 13/06; H01L 21/67709**

(86) Internationale Anmeldenummer:
**PCT/EP2017/079112**

(87) Internationale Veröffentlichungsnummer:
**WO 2018/108408 (21.06.2018 Gazette 2018/25)**

(54) **BEFÖRDERUNGSVORRICHTUNG MIT EINEM STATOR ZUR KONTROLLIERTEN BEFÖRDERUNG EINES TRANSPORTKÖRPERS RELATIV ZUM STATOR**

TRANSPORTING DEVICE WITH A STATOR FOR THE CONTROLLED TRANSPORT OF A TRANSPORT ELEMENT RELATIVE TO THE STATOR

DISPOSITIF DE TRANSPORT COMPRENANT UN STATOR POUR DÉPLACER DE MANIÈRE CONTRÔLÉE UN CORPS DE TRANSPORT PAR RAPPORT AU STATOR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.12.2016 DE 102016224951**

(43) Veröffentlichungstag der Anmeldung:
**23.10.2019 Patentblatt 2019/43**

(73) Patentinhaber: **Robert Bosch GmbH**
**70442 Stuttgart (DE)**

(72) Erfinder: **FRANGEN, Joachim**
**74081 Heilbronn (DE)**

(56) Entgegenhaltungen:
WO-A2-03/103995        DE-A1- 19 960 321
JP-A- H08 111 313       JP-Y1- S4 913 581
US-A1- 2014 265 690

**Beschreibung**

Beschreibung

Die vorliegende Erfindung betrifft Beförderungsvorrichtungen mit einem Stator zur kontrollierten Beförderung eines Transportkörpers relativ zum Stator und ein Verfahren zum Betrieb derselben. Vorzugsweise kann die Erfindung im Rahmen der magnetischen Levitation zum schwebenden Transport und zur Positionierung und/oder Orientierung von Objekten dienen. Die Erfindung kann dabei bevorzugt im Bereich der technischen Fertigung, im Maschinen- und Anlagenbau, in der Logistik oder in der Personenbeförderung zur Anwendung gelangen.

Stand der Technik

Im Rahmen der technischen Fertigung müssen oftmals Objekte wie Werkstoffe, Werkstücke, Werkzeuge oder Erzeugnisse transportiert oder positioniert werden. Dazu werden herkömmlicherweise berührende Systeme eingesetzt, welche in direktem mechanischen Kontakt zu den zu befördernden Objekten stehen, wie beispielsweise Gurtbänder, Taktvorschübe, Rundtische oder mobile Roboter zum Transport von Werkstücken, Achssysteme oder Industrieroboter zur Positionierung von Werkstücken oder Werkzeugen, Sondervorrichtungen für Bearbeitungs- und Prüfprozesse.

Auch berührungslose Beförderungssysteme sind bekannt, welche beispielsweise im Maschinen- und Anlagenbau Anwendung finden, beispielsweise zum Transport von Gütern in Verpackungsmaschinen, zur Positionierung von Maschinenelementen oder zur möglichst präzisen Ausrichtung von Werkzeugen auf das Werkstück, beispielsweise zur Laserbearbeitung, oder in der Halbleiterindustrie zur Belichtung von Substraten in Wafer-Steppern. Dabei können Systeme zur Levitation von Objekten zum Einsatz kommen.

Eine Herausforderung bei der magnetischen Levitation besteht darin, eine stabil in einem Magnetfeld schwebende Konstruktion zu erstellen. Eine weitere Herausforderung besteht darin, die schwebende Konstruktion entsprechend einer Zielvorgabe automatisch in allen sechs Freiheitsgraden (jeweils drei in Translation und Rotation) zu positionieren und/oder zu bewegen, was auch als vollständige magnetische Levitation bezeichnet wird.

Dazu können vereinfachte Systeme verwendet werden, bei denen ein oder mehrere Freiheitsgrade einer magnetisch levitierenden Konstruktion mechanisch berührend geführt werden, z.B. durch ein mechanisches Stützlager, so dass nur noch fünf oder weniger Freiheitsgrade magnetisch geführt werden müssen. Dies stellt somit keine vollständige magnetische Levitation dar.

Ein anderes System ist in der US 8 803 646 A offenbart. Hier wird ein magnetischer Kreisel im Schwebezustand gehalten, indem ein Freiheitsgrad, nämlich die Rotationsachse des Kreisels, nicht durch magnetische Kräfte, sondern durch Inertialkräfte berührungslos stabilisiert wird. Auch dies ist stellt keine vollständige magnetische Levitation dar.

Ferner offenbart die Schrift CA 2 905 783 A eine Anordnung aus rotierenden Dauermagneten in einer Plattform über einem leitfähigen Substrat. Die Plattform erfährt auf dem leitfähigen Substrat eine Auftriebskraft, da die rotierenden Magneten Wirbelströme in dem leitfähigen Substrat hervorrufen, deren Magnetfeld wiederum die Dauermagneten abstößt. Dabei sind mehrere Freiheitsgrade nicht kontrolliert, weshalb es sich auch dabei nicht um eine vollständige magnetische Levitation handelt.

Auch sind luftgelagerte Planarmotoren möglich. Dabei werden Transportkörper berührungslos über einem Stator bewegt. Die Levitation wird durch ein Gleichgewicht von anziehenden und abstoßenden Kräften erreicht, wobei die Anziehung auf magnetischen Kräften zwischen elektromagnetischen Spulen im Transportkörper und einer strukturierten ferromagnetischen Platte im Stator beruht, während die Abstoßung üblicherweise durch ein pneumatisches Luftlager, d.h. durch ein Luftpolster zwischen Transportkörper und Stator, erzeugt wird. Der Levitationsabstand ist typischerweise deutlich kleiner als 1 mm und die Bewegung ist meist auf eine Ebene und somit auf weniger als sechs Freiheitsgrade beschränkt. Darüber hinaus sind die Transportkörper oft elektrisch mit dem Stator verdrahtet, so dass aufgrund der Zuleitung die Bewegungsfreiheit stark eingeschränkt sein kann, insbesondere bei Anwesenheit mehrerer Transportkörper auf einem Stator. Da ein Luftlager verwendet wird und nicht alle sechs Freiheitsgrade des Transportkörpers positionierbar sind, stellt auch dieses System keine vollständige magnetische Levitation bereit.

Magnetisch levitierende Systeme mit sechs Freiheitsgraden und Transportkörpern ohne Kabelanbindung sind beispielsweise aus der Druckschrift WO 2015/017933 A bekannt. Derartige Systeme beruhen oftmals auf der magnetischen Abstoßung eines mit Permanentmagneten bestückten Transportkörpers im Feld eines mit zahlreichen eisenlosen, elektromagnetischen Spulen bestückten Stators. Die Position des Transportkörpers wird von Sensoren erfasst und durch Veränderung der Spulenströme geregelt. Derartige Systeme ermöglichen eine vollständige magnetische Levitation, wobei ihre Eignung für viele Anwendungen jedoch nur begrenzt gegeben ist. Insbesondere weisen derartige Systeme oftmals stark eingeschränkte Bewegungsbereiche in manchen Freiheitsgraden auf, vor allem in der Dimension senkrecht zur Statorebene bzw. Wirkfläche bzw. Beförderungsfläche, so dass beispielsweise ein Z-Hub, ein Nicken und/oder Rollen, nur sehr begrenzt möglich sind.

Zudem ist in herkömmlichen Systemen oftmals ein Stromausfall kritisch, da die Transportkörper im Wand- und Deckenbetrieb unkontrolliert herabfallen können und dabei einen Schaden verursachen können. Sonderlösungen zur Vermeidung dieses Problems sind zwar bekannt, verursachen aber Nachteile bei Kosten, Gewicht und Leistungsfähigkeit.

Aus der JP H08111313 A und der JP S49 13581 Y1 sind magnetische Levitationssysteme bekannt. Aus der WO 03/103995 A2 ist eine gattungsgemäße Vorrichtung bekannt.

Die DE 199 60 321 A1 betrifft eine Vorrichtung zur elektromagnetischen Levitation von Objekten, wobei bodengebundene Magnete an diskreten Punkten in einer zweidimensionalen flächenhaften Anordnung positioniert sind, wobei zumindest einige dieser Magnete als in ihrer oberhalb des Bodens wirksamen magnetischen Feldstärke veränderbare, mit einer Steuereinheit verbundene Magnete ausgebildet sind. Damit kann eine abstoßende Kraft erzeugt werden, über die ein Flugkörper in allen drei Richtungen des Raumes bewegt wird. Mit einer solchen Vorrichtung lässt sich kein Wand- und/oder Deckenbetrieb erreichen und auch keine Beförderung eines Transportkörpers mit sechs Freiheitsgraden.

Es ist daher wünschenswert, eine Beförderungsvorrichtung bereitzustellen, die einen sicheren und effizienten Betrieb zur Beförderung eines Transportkörpers mit drei translatorischen und drei rotatorischen Freiheitsgraden ermöglicht.

Offenbarung der Erfindung

Erfindungsgemäß werden gemäß Anspruch 1 und Anspruch 2 Beförderungsvorrichtungen mit einem Stator zur kontrollierten Beförderung eines Transportkörpers relativ zum Stator und ein Verfahren gemäß Anspruch 28 zum Betrieb derselben mit den Merkmalen der unabhängigen Patentansprüche vorgeschlagen. Vorteilhafte Ausgestaltungen sind Gegenstand der Unteransprüche sowie der nachfolgenden Beschreibung.

Die Erfindung ermöglicht eine kontrollierte Beförderung eines Transportkörpers relativ zu einem Stator, indem eines der beiden Elemente über eine Vielzahl zumindest teilweise beweglich angeordneter Stellmagneten verfügt, deren jeweilige Orientierung (und vorzugsweise auch Position) relativ zu diesem Element über Stellelemente in kontrollierter Weise vorgegeben werden kann, und das andere der beiden Elemente über zumindest zwei unbeweglich mit diesem Element verbundene Stationärmagneten verfügt, wobei die Stationärmagneten mit Stellmagneten magnetisch gekoppelt sind. Die Beförderungsvorrichtung ist dazu eingerichtet, den Transportkörper relativ zum Stator durch eine kontrollierte Positionierung und/oder Orientierung von Stellmagneten zu befördern. Dabei umfasst das Befördern insbesondere, den zumindest einen Transportkörper in eine gewünschte Position und/oder Orientierung relativ zum Stator zu bringen. Die Stellmagneten weisen jeweils zumindest einen Permanentmagneten auf.

Die Erfindung ermöglicht eine vollständige magnetische Levitation des Transportkörpers in sechs Freiheitsgraden, d.h. in drei translatorischen und drei rotatorischen Freiheitsgraden relativ zum Stator. Dies hat den Vorteil, dass die Beförderung des Transportkörpers flexibler erfolgen kann, als bei herkömmlichen Systemen und somit eine vielseitigere Einsetzbarkeit der Beförderungsvorrichtung möglich ist.

Ferner bietet die Erfindung den Vorteil, dass eine Levitation und/oder eine Vorwärtsbewegung des Transportkörpers relativ zum Stator durch eine entsprechende Orientierung und ggf. Positionierung der Stellmagneten mittels der jeweiligen Stellelemente ermöglicht werden. Dadurch kann auf eine Bereitstellung einer komplexen Anordnung und Ansteuerung von Magnetspulen verzichtet werden. Dies reduziert nicht nur die Komplexität der Beförderungsvorrichtung und somit die Herstellungskosten, sondern erlaubt auch den Einsatz von Permanentmagneten, welche oftmals eine sehr viel größere Flussdichte bereitstellen können als für derartige Zwecke verwendbare Magnetspulen. Dies kann wiederum eine größere Hubhöhe bzw. einen größeren Luftspalt zwischen dem Stator und dem Transportkörper ermöglichen, wodurch sich ein größerer Bewegungsspielraum bei Bewegungen in Z-Richtung und oder im Nick- und Roll-Winkelbereich ergeben kann. Ferner bietet dies den Vorteil, dass auch eine Unterbrechung der Versorgung mit elektrischer Energie nicht zwangsläufig zu einer Fehlfunktion oder gar der Verursachung eines Schadens führen muss. Insbesondere führt eine Unterbrechung der Leistungsversorgung nicht zu einem Verlust des Magnetfelds bzw. der magnetischen Kopplung zwischen Stator und Transportkörper. Beispielsweise können im Falle einer Unterbrechung der Leistungsversorgung die Kopplungskräfte zwischen den Stellmagneten und den Stationärmagneten zunehmen, sobald die Position und/oder die Orientierung der Stellmagneten der anziehenden Kraftwirkung der Stationärmagneten nachgibt, woraufhin der Transportkörper auf den Stator gezogen wird und so gegen unkontrolliertes Herabfallen gesichert ist. Darüber hinaus bietet die Erfindung den Vorteil, dass die magnetische Kopplung zwischen dem Stator und dem Transportkörper sowohl eine Levitation des Transportkörpers, d.h. einen Hub über dem Stator, bewirken kann, als auch eine Fortbewegung des Transportkörpers relativ zum Stator, d.h. Beförderung, ohne dass dafür noch weitere berührende oder berührungslose Systeme zwingend erforderlich wären. Dadurch kann ein berührungsloser Transport ermöglicht werden, so dass eine erfindungsgemäße Beförderungsvorrichtung auch in Umgebungen mit erhöhten Sauberkeitsanforderungen zum Einsatz gelangen kann. Beispielsweise kann der Transportkörper in einer Umgebung mit erhöhten Sauberkeitsanforderungen befördert werden, während der Stator außerhalb in einer Umgebung mit geringeren Sauberkeitsanforderungen angeordnet ist. Durch einen Luftspalt zwischen dem Stator und dem Transportkörper können beispielsweise Trennelemente verlaufen, um die verschiedenen Sauberkeitsbereiche zu trennen. Somit eignet sich die Erfindung auch zur Anwendung bei biologischen, chemischen und/oder pharmazeutischen Verfahren, sowie beispielsweise in gasdichten, flüssigkeitsdichten und/oder abgekapselten Bereichen.

Ferner bietet die Erfindung den Vorteil, dass weder im Transportkörper noch im Stator zwingend Magnetspulen bereitgestellt werden müssen, so dass eine Erwärmung des Transportkörpers und/oder des Stators durch in solchen Spulen auftretende Ströme vermieden werden kann. Dies begünstigt einen Einsatz der Erfindung in wärmekritischen Umgebungen oder zur Beförderung von wärmeempfindlichen Objekten und verbessert die Energieeffizienz der Beförderungsvorrichtung, da die Dissipation von elektrischer Energie reduziert werden kann.

Durch die Levitation bzw. Beförderung mittels magnetischer Kopplung kann auch auf effiziente Weise eine Entkopplung des Transportkörpers bzw. der Beförderungsvorrichtung von Schwingungen und/oder Vibrationen und/oder Körperschallwellen erreicht werden, wodurch die Erfindung auch bei der Beförderung von empfindlichen Objekten und/oder von Personen zum Einsatz kommen kann.

Vorzugsweise weist die Beförderungsvorrichtung eine Mehrzahl von Stellmagneten und/oder eine Mehrzahl von Stationärmagneten auf. Besonders bevorzugt sind die Stellmagneten und/oder die Stationärmagneten über eine Beförderungsfläche in oder am Stator bzw. in oder am Transportkörper angeordnet, so dass der Transportkörper entlang der Beförderungsfläche levitiert und/oder befördert werden kann. Auf diese Weise lässt sich ein größerer Bereich erzeugen, in welchem der Transportkörper befördert werden kann. Besonders bevorzugt weisen die Stellmagneten insgesamt eine Anzahl von Freiheitsgraden auf, welche mindestens so groß ist wie die Anzahl der Freiheitsgrade des Transportkörpers, in welchen der Transportkörper kontrolliert befördert bzw. positioniert werden soll. Soll beispielsweise der Transportköper in sechs Freiheitsgraden befördert und/oder positioniert werden, ist es vorteilhaft, mehrere Stellmagneten bereitzustellen, welche insgesamt sechs oder mehr Freiheitsgrade aufweisen. Beispielsweise können dazu die Stellmagneten derart eingerichtet sein, dass zu jedem Zeitpunkt der Transportköper mit zumindest sechs Stellmagneten wechselwirkt.

Vorzugsweise ist das Magnetfeld der Stellmagneten und/oder das Magnetfeld der zumindest zwei Stationärmagneten der Beförderungsfläche zugewandt, d.h. ein Magnetpol ist der Beförderungsfläche zugewandt. Die Beförderungsfläche ist dabei die Fläche, entlang welcher der Transportkörper in kontrollierter Weise relativ zum Stator befördert wird. Insbesondere kann die Beförderungsfläche mit einer Statorebene und/oder einer Wirkfläche des Stators zusammenfallen. Beispielsweise kann eine zwischen dem Stator und einem von dem Stator levitierten Transportkörper liegende Fläche die Beförderungsfläche darstellen. Eine derartige Anordnung bietet den Vorteil, dass die magnetische Kopplung zwischen den Stellmagneten und den Stationärmagneten vergrößert bzw. optimiert werden kann. Vorzugsweise sind die Magnetpole der Stellmagneten und Stationärmagneten einander zugewandt bzw. derart angeordnet, dass deren magnetische Felder einen Überlapp aufweisen und/ oder wechselwirken. Vorzugsweise werden dabei die magnetischen Felder in von der Beförderungsfläche abgewandten Richtungen minimiert.

Vorzugsweise weisen die zumindest zwei Stationärmagneten jeweils zumindest einen Permanentmagneten auf. Die Stellmagneten weisen jeweils zumindest einen Permanentmagneten auf. Dies hat den Vorteil, dass im Stator und/oder im Transportkörper die Verwendung von Magnetspulen verringert oder gar ganz vermieden werden kann und somit der Energieverbrauch der Beförderungsvorrichtung gesenkt werden kann. Ferner kann mittels Permanentmagneten ein im Vergleich zu Magnetspulen sehr starkes Magnetfeld erzeugt werden, welches darüber hinaus auf kleinem Raum bereitgestellt werden kann. Auch ist bei der Verwendung von Permanentmagneten zur Bereitstellung des Magnetfeldes keine Versorgung der Magneten mit elektrischer Leistung erforderlich, wie dies beispielsweise bei der Verwendung von Magnetspulen der Fall ist. Zudem dissipieren Permanentmagneten keine elektrische Leistung und tragen somit nicht zu einer unerwünschten Erwärmung der Beförderungsvorrichtung bei. Besonders bevorzugt weisen ein Stationärmagnet und/oder ein Stellmagnet ausschließlich einen oder mehrere Permanentmagneten auf, ohne zusätzlich Magnetspulen aufzuweisen. Auf diese Weise kann beispielsweise vermieden werden, dass der Transportkörper mit einer bei der Fortbewegung hinderlichen Zufuhrleitung für elektrische Energie kontaktiert werden muss.

Vorzugsweise liefert ein Permanentmagnet (an einem Punkt der Oberfläche) eine magnetische Flussdichte von zumindest 0,05 T, bevorzugt zumindest 0,1 T, weiter bevorzugt zumindest 0,25 T, noch weiter bevorzugt zumindest 0,5 T, besonders bevorzugt zumindest 0,75 T, am meisten bevorzugt zumindest 1 T auf. Insbesondere können Permanentmagneten derart ausgewählt werden, dass durch die gewählten Flussdichten die zum Transport und/oder zur Positionierung des Transportkörpers erforderlichen Kräfte und Momente erzielt werden. Permanentmagneten mit einer größeren Flussdichte können beispielsweise dazu dienen, einen größeren Hub zu bewirken und/oder höhere Beschleunigungen zu bewirken und/oder schwerere Lasten mit dem Transportkörper zu befördern.

Vorzugsweise weist ein Stellmagnet eine Magnetgruppe auf, welche vorzugsweise mehrere Permanentmagneten und/oder Magnetspulen aufweist. Vorzugsweise bilden auch die Stationärmagneten zumindest eine Magnetgruppe, wobei die Magnetgruppe vorzugsweise mehrere Permanentmagneten und/oder Magnetspulen aufweist. Insbesondere für den Fall, dass die mehreren Magneten einer Magnetgruppe entlang einer Geraden angeordnet sind, kann es vorteilhaft sein, die Magneten derart anzuordnen, dass die mehreren Magneten derart orientiert bzw. angeordnet sind, dass deren magnetische Dipole nicht parallel ausgerichtet sind bzw. nicht in die gleiche Richtung zeigen, insbesondere nicht alle parallel zu der Geraden ausgerichtet sind. Eine nicht-parallele Anordnung der Dipole kann dabei für eine kontrollierte Beförderung bzw. Bewegung des Transportkörpers in allen sechs Freiheitsgraden von Vorteil sein.

Besonders bevorzugt ist die Mehrzahl von Permanentmagneten und/oder Magnetspulen der zumindest einen Magnetgruppe zumindest teilweise gemäß einem Halbach-Array angeordnet. Dies bietet den Vorteil, dass sich die durch die mehreren Magneten erzeugten Magnetfelder in eine Richtung vom Halbach-Array wegführend verstärken und in eine andere Richtung vom Halbach-Array wegführend verringern oder gar ganz auslöschen. Dies kann beispielsweise dahingehend vorteilhaft sein, dass die Magnetfelder in einer Richtung zwischen dem Stator und dem Transportkörper verstärkt werden können, während sich die Magnetfelder in andere Richtungen reduzieren oder gar ganz auslöschen. Somit kann das Magnetfeld auf eine besonders effiziente Weise zur Levitation genutzt werden und/oder die ein Halbach-Array aufweisenden Magneten aneinander angrenzend, insbesondere auf engem Raum, angeordnet werden, ohne sich gegenseitig negativ zu beeinflussen. Vorzugsweise werden die Halbach-Arrays derart angeordnet, dass sich ein Magnetfeld der Magnetgruppe vorzugsweise zur Beförderungsfläche bzw. Wirkfläche hin erstreckt. Insbesondere kann durch die Anordnung als Halbach-Array bei gleichen Kopplungskräften und -momenten das Gesamtgewicht und/oder das Trägheitsmoment der Magneten reduziert werden. Am meisten bevorzugt sind flächige Anordnungen von Magneten, die in verschiedenen Raumrichtungen Halbach-Arrays ausbilden, um hohe Kräfte und Momente in allen Freiheitsgraden zu übertragen.

Bevorzugt weist das Stellelement ein Antriebselement auf, welches dazu eingerichtet ist, die Orientierung und ggf. die Position des damit verbundenen Stellmagneten in kontrollierter Weise zu ändern. Beispielsweise kann ein solches Antriebselement einen Elektromotor aufweisen, welcher direkt oder über ein Getriebe und/oder ein Gestänge mit dem Stellmagneten verbunden ist, um diesen zu bewegen. Zudem kann ein Antriebselement derart eingerichtet sein, dass mehrere Stellmagneten damit bewegt werden können. Derartige Anordnungen haben den Vorteil, dass die mit einem Stellelement verbundenen Stellmagneten individuell in ihrer Position bzw. Orientierung geändert werden können. Beispielsweise kann das Stellelement derart eingerichtet sein, dass es den bzw. die Stellmagneten um eine Achse und/oder einen Schwerpunkt des Stellmagneten rotieren kann. Des Weiteren kann ein Antriebselement so eingerichtet sein, dass damit mehr als ein Freiheitsgrad des mindestens einen Stellmagneten bewegt werden kann. Weiter bevorzugt weist das Stellelement ein Sensorelement auf, welches dazu eingerichtet ist, um die Orientierung und ggf. die Position des mit dem Stellelement verbundenen Stellmagneten zu ermitteln. Dies ermöglicht es, die Orientierung und ggf. auch die Position des Stellmagneten zu regeln und den gewünschten Effekt mittels des Stellmagneten auf effiziente und effektive Weise zu bewirken. Weiter bevorzugt weist das Stellelement ein Kontrollelement auf, welches dazu eingerichtet ist, um die Orientierung und ggf. die Position des mit dem Stellelement verbundenen Stellmagneten mittels des Antriebs auf einen vorbestimmten Wert einzustellen. Beispielsweise kann das Kontrollelement eine Steuer- und/oder Regelungseinheit aufweisen, mittels welcher die Bewegung des Stellmagneten über das Antriebselement gesteuert und/oder geregelt wird. Auf diese Weise kann die Positionierung bzw. Orientierung des Stellmagneten besonders schnell und/oder genau erfolgen.

Darüber hinaus kann eine Beförderungsvorrichtung auch eine Positionsbestimmungseinheit aufweisen, welche dazu eingerichtet ist, eine relative Position und/oder Orientierung des zumindest einen Transportkörpers relativ zum Stator zu ermitteln. Beispielsweise kann die Positionsbestimmungseinheit optische Sensoren und/oder kapazitive Sensoren und/oder Magnetfeldsensoren, wie etwa Hall-Sensoren, aufweisen, welche auf Basis des von einem Transportkörper verursachten Magnetfeldes zumindest teilweise eine Position und/oder Orientierung des Transportkörpers relativ zum Stator ermitteln.

Weitere Vorteile und Ausgestaltungen der Erfindung ergeben sich aus der Beschreibung und der beiliegenden Zeichnung.

Es versteht sich, dass die vorstehend genannten und die nachfolgend noch zu erläuternden Merkmale nicht nur in der jeweils angegebenen Kombination, sondern auch in anderen Kombinationen oder in Alleinstellung verwendbar sind, ohne von der vorliegenden Erfindung abzuweichen.

Die Erfindung ist anhand von Ausführungsbeispielen in den Zeichnungen schematisch dargestellt und wird im Folgenden unter Bezugnahme auf die Zeichnungen ausführlich beschrieben, ohne jedoch auf die gezeigten Ausführungsbeispiele beschränkt zu sein.

Gleiche oder ähnliche Elemente werden dabei mit gleichen Bezugszeichen versehen. Entsprechende Erläuterungen werden im Sinne der Knappheit nicht wiederholt.

Figurenbeschreibung

Figuren 1A bis 1E zeigen Beförderungsvorrichtungen gemäß bevorzugter Ausführungsformen in einer schematischen Darstellung.

Figuren 2A und 2B zeigen einen Transportkörper gemäß einer bevorzugten Ausführungsform.

Die Figuren 3A bis 3M zeigen verschiedene Anordnungen von Stationärmagneten bzw. von Magnetgruppen in einer schematischen Darstellung in Draufsicht.

Figuren 4A bis 4C zeigen bevorzugte Ausführungsformen eines Transportkörpers.

Figur 5 zeigt einen Transportkörper gemäß einer bevorzugten Ausführungsform mit einer Zusatzfunktion.

Figuren 6A bis 6D zeigen in einer schematischen Darstellung Statoren gemäß bevorzugten Ausführungsformen.

Figuren 7A bis 7E zeigen beispielhafte Anordnungen von Magnetgruppen bzw. Stellmagneten.

Figuren 8A bis 8H zeigen bevorzugte Ausführungsformen von Stellmagneten und Magnetgruppen und bevorzugte Anordnungen.

Figuren 9A und 9B zeigen in schematischen Darstellungen bevorzugter Ausführungs-formen von Stellelementen.

Figur 9C zeigt in einem Blockdiagramm ein beispielhaftes Funktionsprinzip eines Stellelements.

Figur 10 zeigt eine bevorzugte Ausführungsform einer Positionsbestimmungseinheit.

Figur 11 zeigt ein beispielhaftes Steuerungsdiagramm.

Figuren 12A bis 12C zeigen bevorzugte Ausführungsformen von Beförderungsvorrichtungen.

Figur 13 zeigt eine bevorzugte Ausführungsform eines Fahrzeugs.

Figur 14 zeigt ein beispielhaftes Verfahrensablaufschema.

Detaillierte Beschreibung der Zeichnung

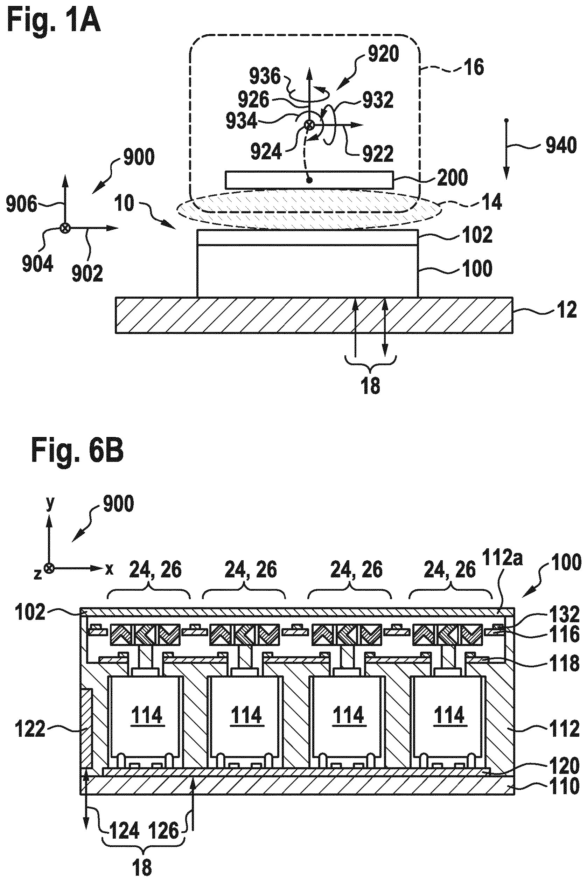

**Figur 1A** zeigt eine Beförderungsvorrichtung 10 gemäß einer bevorzugten Ausführungsform in einer schematischen Darstellung mit zugehörigen Koordinatensystemen 900 und 920. Die dargestellte Beförderungsvorrichtung 10 ist auf einem Maschinentisch 12 angeordnet und weist einen Stator 100 und einen Transportkörper 200 auf. Zwischen dem Stator 100 und dem Transportkörper 200 ist schematisch ein Levitationsfeld 14 dargestellt, welches in diesem Fall ein aktiv geregeltes Magnetfeld ist. Das Levitationsfeld 14 wird durch Stellmagneten und Stationärmagneten (nicht gezeigt) an der Wirkfläche 102 des Stators 100 erzeugt, die im Stator 100 bzw. im Transportkörper 200 ausgebildet sind. Das Levitationsfeld 14 befindet sich zwischen dem Stator 100 und dem Transportkörper 200, wobei der Transportkörper 200 im Levitationsfeld 14 schwebt. Die gestrichelte Linie zeigt schematisch eine optional anbringbare hermetische Abdichtung 16, welche es ermöglicht, mit dem Stator 100 außerhalb der hermetischen Abdichtung 16 den Transportkörper 200 innerhalb der hermetischen Abdichtung 16 zu befördern. Ferner sind schematisch Anschlüsse 18 gezeigt, mittels welcher die Beförderungsvorrichtung 10 mit elektrischer Energie versorgt werden kann und über welche Kommunikationsdaten zu- und/oder abgeführt werden können.

Die Position und Orientierung des Transportkörpers relativ zum Stator kann dabei in einem Statorkoordinatensystem 900, welches durch eine x-Richtung 902, eine y-Richtung 904 und eine z-Richtung 906 aufgespannt wird, dargestellt werden. Der Transportkörper besitzt ein eigenes Transportkörperkoordinatensystem 920, welches durch eine x1-Richtung 922, eine y1-Richtung 924, und z1-Richtung 926 aufgespannt wird und einen Roll-Winkel 932, einen Nick-Winkel 934 und einen Gier-Winkel 936 aufweist.

Die Beförderungsvorrichtung 10 wird dabei vorzugsweise derart geregelt, dass der Transportkörper 200 stabil levitiert und hinsichtlich der Translation und Rotation auf einer vorgegebenen Sollkurve geführt wird.

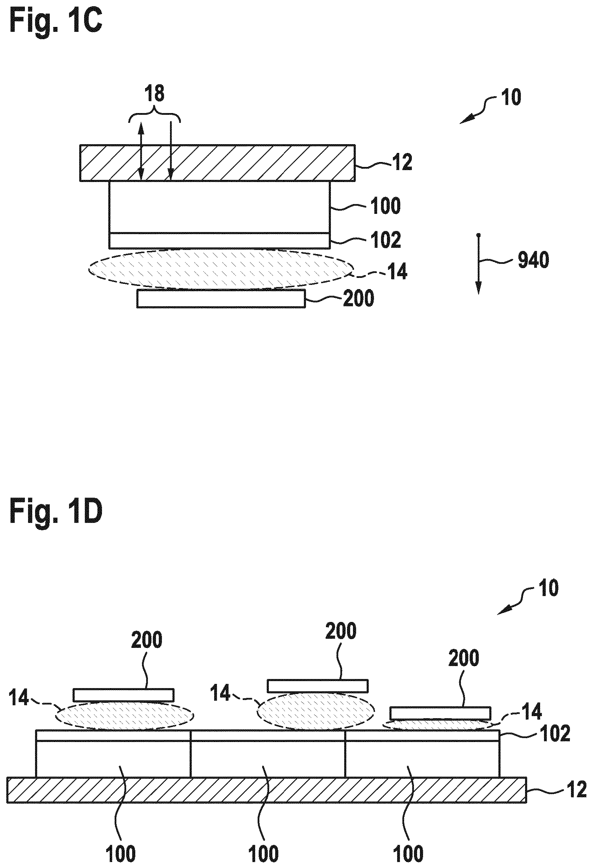

Während Figur 1A eine Beförderungsvorrichtung 10 im Tischbetrieb zeigt, d.h. in einer Ebene angeordnet bzw. aufliegend, so dass der Transportkörper 200 durch die Erdanziehungskraft 940 in Richtung des Stators 100 beschleunigt wird, zeigt **Figur 1B eine** Beförderungsvorrichtung 10 im Wandbetrieb, bei der die Schwerkraft den Transportkörper im Wesentlichen parallel zur Beförderungsfläche beschleunigt. Dabei wird die magnetische Kopplung zwischen dem Stator 100 und dem Transportköper 200 so eingestellt, dass die Kräfte zur Kompensation der Schwerkraft ebenfalls parallel zur Beförderungsfläche wirken. Das Levitationsfeld 14 verhindert dabei ein Abrutschen und/oder Abstürzen des Transportkörpers 200. Die Stellmagneten weisen jeweils zumindest einen Permanentmagneten auf. Sofern Stationärmagneten (nicht gezeigt) Permanentmagneten aufweisen, kann auch bei einer Unterbrechung der Zufuhr von elektrischer Leistung gegebenenfalls ein Abrutschen und/oder Abstürzen verhindert werden. Gleiches gilt für eine Beförderungsvorrichtung 10 im Deckenbetrieb, die in **Figur 1C** schematisch dargestellt ist.

**Figur 1D** zeigt in einer schematischen Darstellung eine Beförderungsvorrichtung 10 mit drei Transportkörpern 200, welche über drei aneinander angrenzend angeordnete Statoren 100 bzw. Stator-Module transportiert werden, wobei die Stator-Module eine ebene Wirkfläche 102 bilden. Ferner ist in Figur 1 D eine Positionierung der Transportkörper 200 in unterschiedlichen Hubhöhen bzw. in unterschiedlichen Abständen in z-Richtung 906 gezeigt.

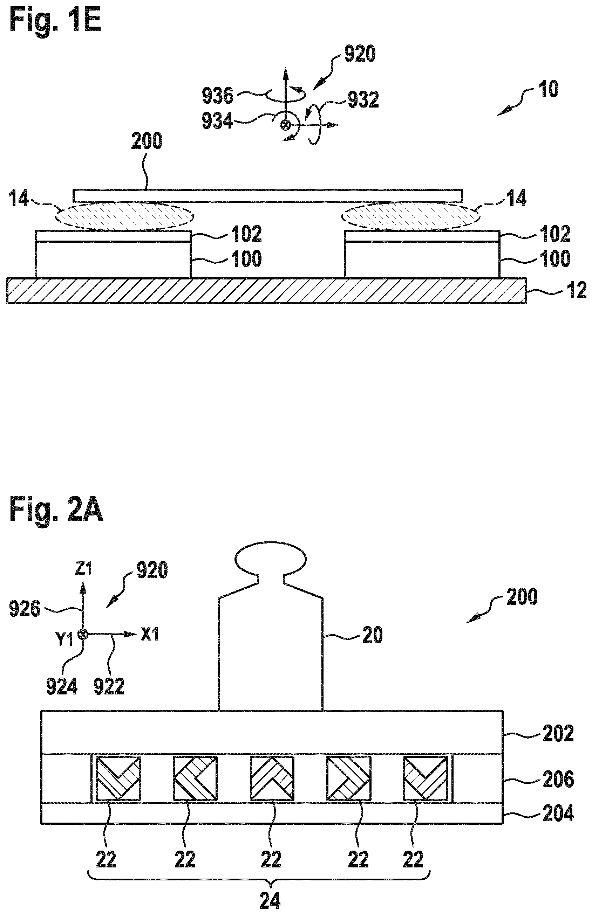

**Figur 1E** zeigt in einer schematischen Darstellung eine Beförderungsvorrichtung 10 gemäß einer weiteren bevorzugten Ausführungsform, bei welcher ein Transportkörper 200 durch zwei separate Statoren 100 befördert bzw. positioniert bzw. orientiert wird, wobei jeder Stator nur an einen Teilbereich der Magnetanordnung im Transportkörper ankoppelt. Auf diese Weise kann der Transportkörper 200 um den Gierwinkel 936 gedreht und/oder um den Roll-winkel 932 gekippt und/oder um den Nickwinkel 934 geneigt werden.

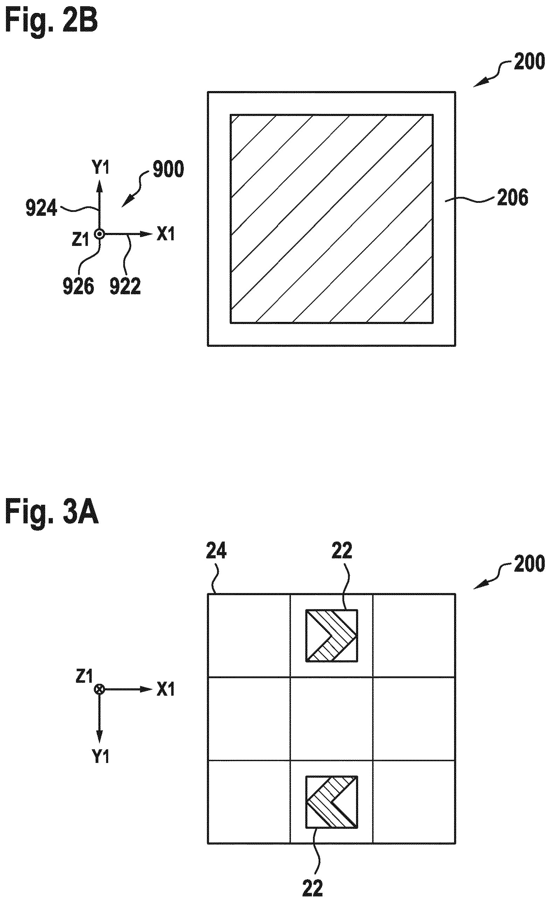

**Figur 2A** zeigt einen Transportkörper 200 gemäß einer bevorzugten Ausführungsform in einer schematischen Darstellung in einem Querschnitt in der X1/Z1-Ebene, wobei der Transportkörper 200 eine Magnetgruppe 24 von Stationärmagneten 22 aufweist. **Figur 2B** zeigt den Transportkörper aus Figur 2A in Draufsicht. Der Transportkörper 200 weist ferner ein oberes Deckelement 202 und ein unteres Deckelement 204 auf, welche an die Magnetgruppe 24 oben bzw. unten angrenzend angeordnet sind. In der gezeigten Ausführungsform werden mit oben und unten verschiedene Positionen entlang der z1-Richtung 926 bezeichnet. An den Seiten des Transportkörpers 200 in x1-Richtung 922 und y1-Richtung 924 ist an die Magnetgruppe 24 angrenzend ein Randelement 206 ausgebildet.

Der Transportkörper 200 kann dabei als ein mechanisches Bindeglied zwischen einem Transportgut 20 einerseits und dem Stator 100 andererseits dienen. Vorzugsweise ist der Transportkörper 200 als ein mechanisch starres Element ausgebildet und dazu eingerichtet, auf einer Oberseite des oberen Deckelements 202 ein Transportgut 20 zu stützen bzw. zu transportieren. Vorzugsweise kann das Transportgut 20 auf dem Transportkörper 200 fixiert werden und dann gemeinsam mit dem Transportkörper 200 auf einer Sollkurve über dem Stator 100 geführt und/oder stabil an einer Sollposition gehalten werden. Der Transportkörper 200 ist gemäß der gezeigten Ausführungsform elektrisch passiv, d.h. zur Ausführung seiner Funktion benötigt er keine elektrische Energie oder Anschlüsse und weist insbesondere keine Stellmagneten auf.

Der Transportkörper 200 umfasst gemäß der gezeigten Ausführungsform eine Vielzahl von Stationärmagneten 22 in einer flächigen Anordnung in der X1/Y1-Ebene, welche als eine Magnetgruppe 24 in einer geometrischen Anordnung angeordnet sind, wobei die geometrische Anordnung der Stationärmagneten 22 relativ zum Transportkörper 200 fixiert ist und sich die Stationärmagneten 22 somit relativ zum Transportkörper 200 nicht bewegen. Beispielsweise können das obere Deckelement 202 und/oder das untere Deckelement 204 und/oder das Randelement 206 dazu eingerichtet sein, die Stationärmagneten 22 zumindest teilweise in ihrer Position bzw. in ihrer geometrischen Anordnung zu fixieren. Alternativ oder zusätzlich kann der Transportkörper 200 eines oder mehrere weitere Bauteile aufweisen, um die Stationärmagneten 22 zu fixieren. Vorzugsweise umfassen die Stationärmagneten 22 einen Permanentmagneten und/oder sind als Permanentmagneten ausgebildet. Besonders bevorzugt weisen die Stationärmagneten 22 Permanentmagneten aus Selten-Erd-Legierungen auf.

Unter der Position eines Magneten bzw. Stationärmagneten 22 wird dabei vorzugsweise die Position seines Schwerpunkts verstanden. Eine Magnetisierungsrichtung des jeweiligen Stationärmagneten wird durch einen Dipolvektor beschrieben, welcher symbolisch als entsprechender Pfeil dargestellt ist. So ist in Figur 2A erkennbar, dass gemäß der gezeigten Ausführungsform jeder Stationärmagnet 22 hinsichtlich seiner Magnetisierungsrichtung anders angeordnet bzw. ausgerichtet ist, als die jeweiligen benachbart angeordneten Stationärmagneten 22. Sie bilden im gezeigten Fall ein Halbach-Array, dessen Magnetfeld in -Z1-Richtung besonders stark ist und in der Gegenrichtung abgeschwächt ist. Vorzugsweise werden als Stationärmagneten 22 Magneten verwendet, die im Wesentlichen homogen magnetisiert sind, so dass die Dipolvektoren einzelner Teilvolumina des jeweiligen Stationärmagneten 22 annähernd in die gleiche Richtung weisen wie der Gesamt-Dipolvektor des Stationärmagneten 22. Der Dipolvektor zeigt in die Richtung der Pfeilspitze.

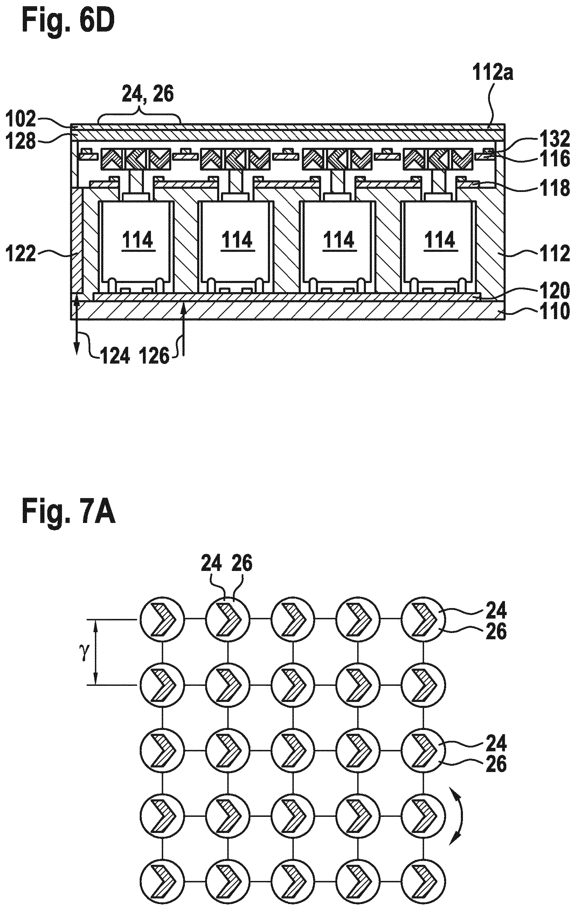

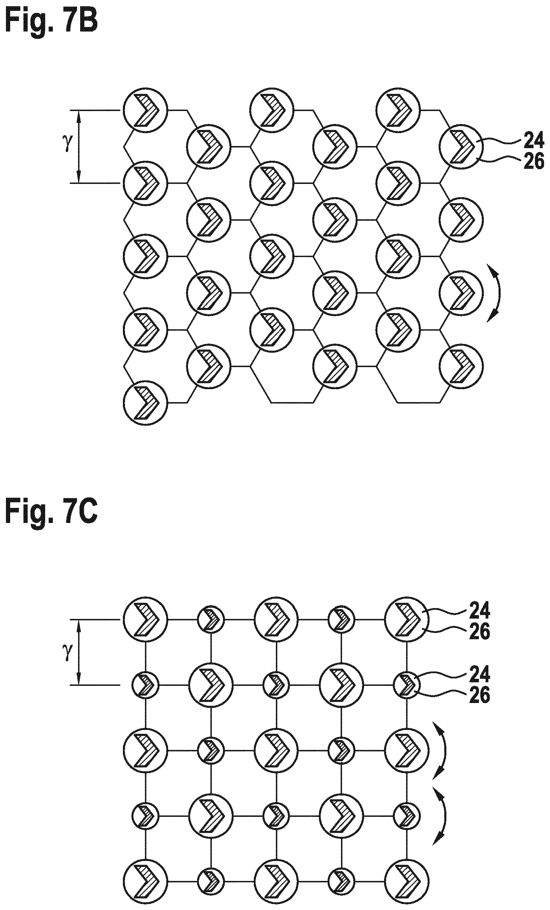

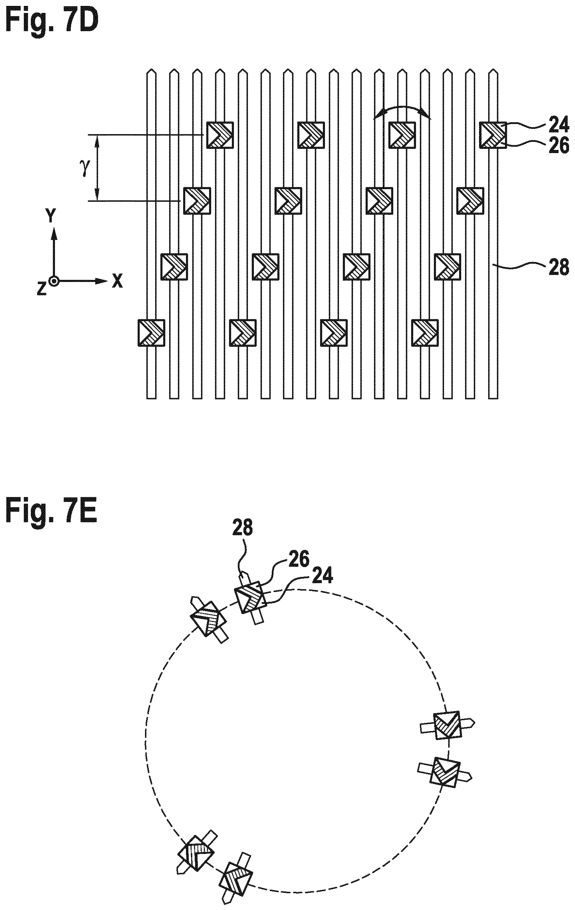

Die Anordnung der Stationärmagneten 22 im Transportkörper 200 wird vorzugsweise derart auf eine Anordnung von Stellmagneten 26 (siehe beispielsweise Figur 7) im Stator 100 abgestimmt bzw. angepasst, dass in einem Arbeitsbereich des Transportkörpers 200 auf dem jeweiligen Stator 100 die zum Transport erforderlichen Kräfte und Momente vom Stator 100 auf den Transportkörper 200 übertragen werden können und/oder stets alle gewünschten Freiheitsgrade des Transportkörpers 200 unabhängig steuerbar sind.

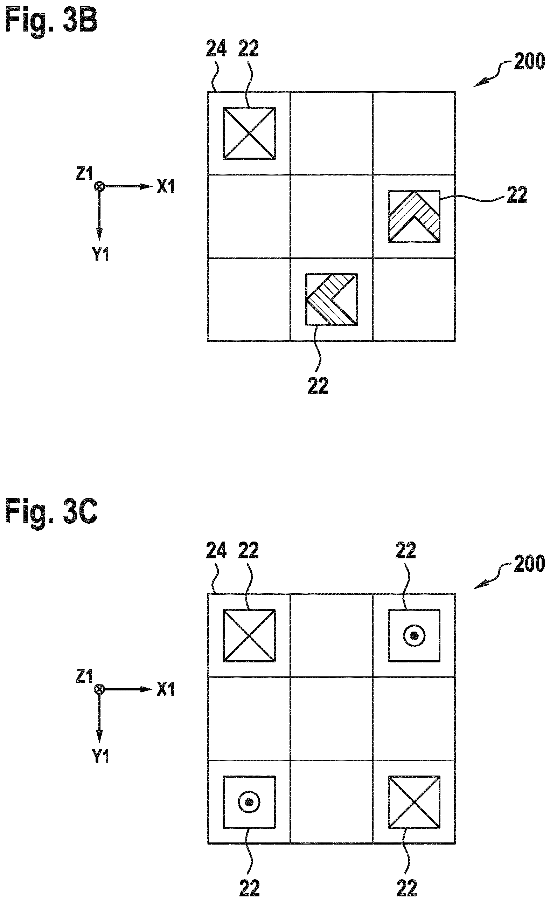

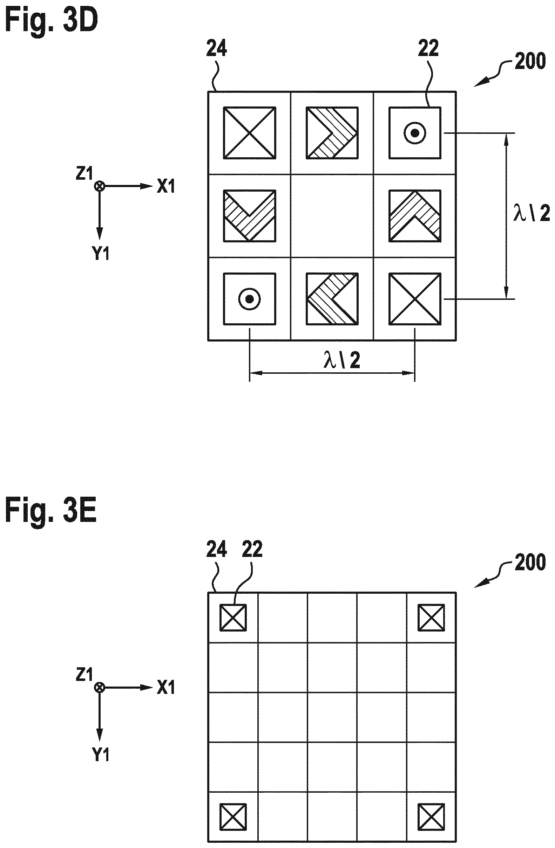

Die **Figuren 3A bis 3M** zeigen verschiedene Anordnungen von Stationärmagneten 22, welche eine Magnetgruppe 24 bilden, in einer schematischen Darstellung in Draufsicht. Auch bei diesen Figuren indizieren die Pfeile die Magnetisierungsrichtung des jeweiligen Stationärmagneten 22, wobei die mit einem Punkt bzw. mit einem X versehenen Stationärmagneten 22 eine Magnetisierungsrichtung aufweisen, welche in z1-Richtung 926 aus der Zeichenebene heraus bzw. in die Zeichenebene hinein verläuft.

Die Figuren 3A bis 3G zeigen Anordnungen von Stationärmagneten 22 in einem regelmäßigen, rechteckigen Raster. Bevorzugt weist ein Transportkörper 200 mindestens zwei Stationärmagneten 22 auf (siehe Figur 3A), welche linear auf einer Geraden angeordnet sind, wobei das Dipolmoment mindestens eines der Stationärmagneten nicht parallel zu dieser Geraden orientiert ist. Dies ist besonders vorteilhaft, um den Transportkörper 200 in allen sechs Freiheitsgraden steuern bzw. kontrolliert bewegen zu können. Vorzugsweise besitzt ein Transportkörper 200 jeweils mindestens drei Stationärmagneten 22 (siehe Figuren 3B bis 3G), die sich in einer räumlichen Ebene, beispielsweise in der x1-y1-Ebene, befinden und/oder eine komplexe dreidimensionale, räumliche Anordnung bilden.

Anordnungen, bei welchen die Stationärmagneten 22 alle in einer Anordnungsebene angeordnet sind, sind besonders für Anwendungen geeignet, bei denen vorwiegend translatorische Bewegungen parallel zur Anordnungsebene auszuführen sind und/oder Rotationen um die z-Achse des Stators 100 bzw. die z1-Achse des jeweiligen Transportkörpers 200.

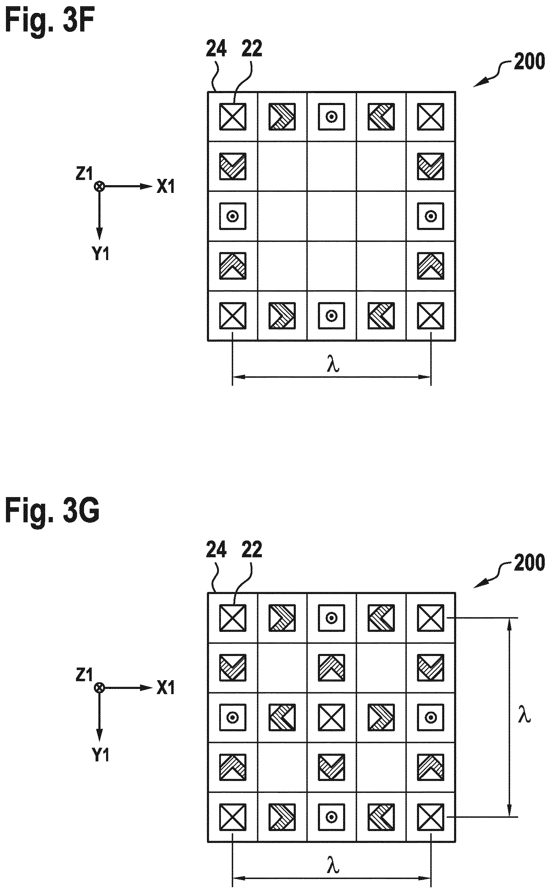

Die Magnetgruppen 24 weisen vorzugsweise Stationärmagneten 22 auf, die als zumindest ein Halbach-Array angeordnet sind. Das bzw. die Halbach-Arrays sind vorzugsweise derart orientiert bzw. angeordnet, dass das Magnetfeld bzw. die Magnetfeldstärke in Richtung des Stators 100 erhöht wird und/oder in Richtung des Transportgutes 20 und/oder in Richtung möglicher benachbarter Transportkörper 200, welche gegebenenfalls auf demselben Stator 100 befördert werden, reduziert wird. Beispielhafte Anordnungen von Stationärmagneten 22, welche unter anderem Halbach-Arrays bilden, sind in den Figuren 3D, 3F und 3G dargestellt. Eine Länge λ indiziert dabei die Länge einer Halbach-Periode, d.h. einer Periode eines Halbach-Arrays.

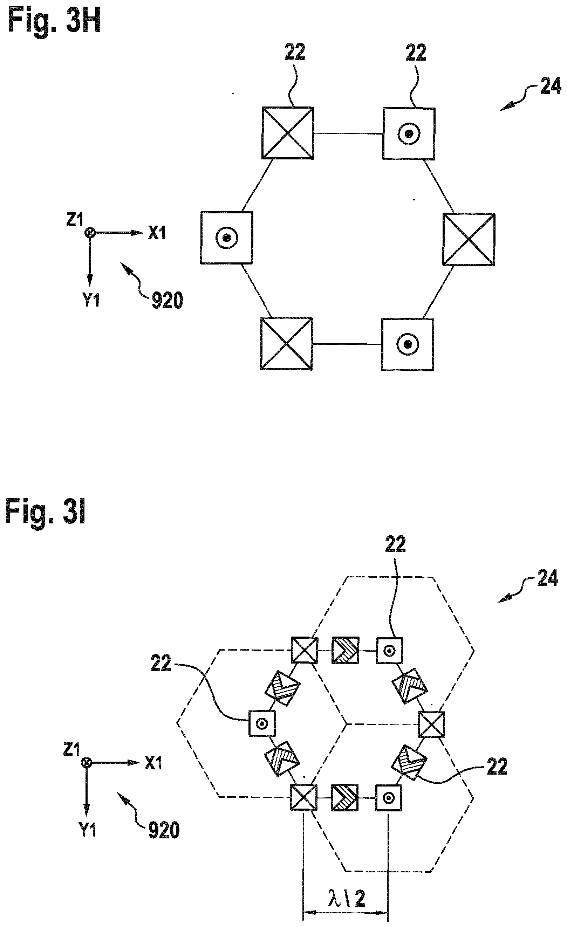

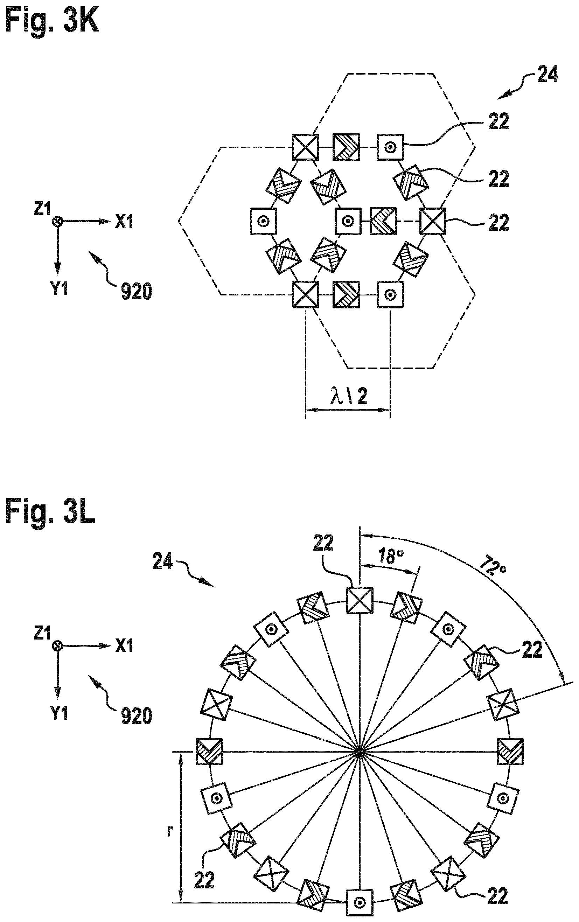

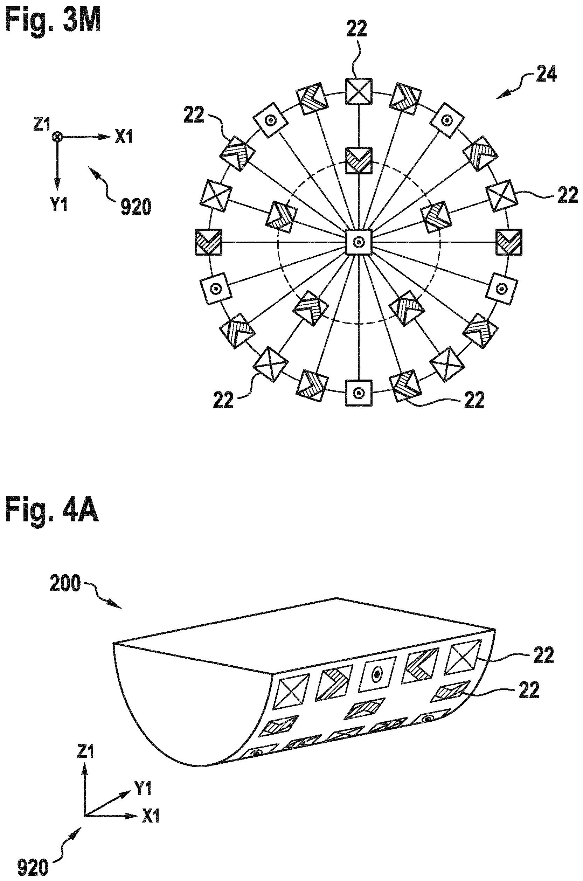

Die Figuren 3H bis 3K zeigen Magnetgruppen 24, bei welchen die Stationärmagneten 22 entlang einem hexagonalen Raster angeordnet sind. Die Anordnungen gemäß Figuren 3I und 3K basieren dabei auf einer 2-dimensionalen Anordnung von Halbach-Arrays. Die Figu-ren 3L und 3M zeigen Magnetgruppen 24, bei welchen die Stationärmagneten 22 entlang einem zirkularen Raster angeordnet sind. Insbesondere zeigt Figur 3L eine Anordnung, bei welcher die Stationärmagneten 22 in fünf Halbach-Arrays bzw. Halbach-Perioden über jeweils einen Winkelbereich von 72° angeordnet sind. Die Stationärmagneten 22 sind dabei äquidistant mit einem Winkelabstand von 18° angeordnet. Die Anordnung in Figur 3M weist zusätzlich zur in Figur 3L gezeigten Anordnung fünf radial angeordnete Halbach-Arrays auf, welche sich einen gemeinsamen Stationärmagneten 22 im Mittelpunkt bzw. im Zentrum der zirkularen Anordnung teilen. Derartige Anordnungen können vorteilhaft mit einer Stator-Magnetanordnung mit quadratischem Raster kombiniert werden. Insbesondere kann eine derartige Anordnung vorteilhaft sein, um Singularitäten hinsichtlich der Anordnung von Stellmagneten und Stationärmagneten relativ zueinander zu vermeiden.

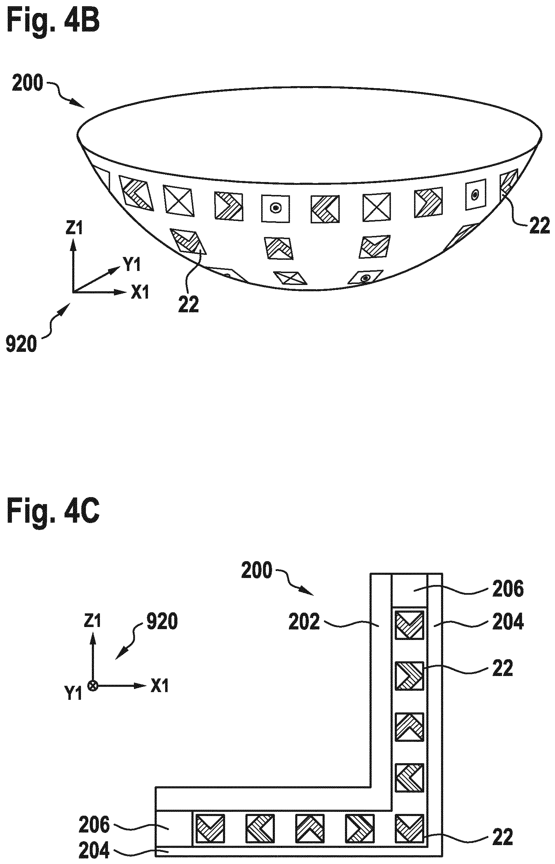

Die **Figuren 4A bis 4C** zeigen bevorzugte Ausführungsformen eines Transportkörpers 200, welche eine Magnetgruppe 24 aufweisen, bei denen die Stationärmagneten 22 in einer dreidimensionalen Anordnung angeordnet sind. Zur besseren Darstellung sind die untere Deckschicht 204 und die obere Deckschicht 202 nicht dargestellt. Figur 4A zeigt dabei eine teilzylindrische Anordnung der Stationärmagneten 22, welche beispielsweise bei Drehungen um die y1-Achse einen vergrößerten Schwenkbereich bereitstellen kann. Figur 4B zeigt eine kugelsegmentförmige Anordnung der Stationärmagneten 22, welche sowohl bei Drehungen um die x1-Achse als auch um die y1-Achse einen größeren Schwenkbereich bereitstellen kann. Beide Anordnungen unterliegen nicht notwendigerweise Beschränkungen hinsichtlich einer Drehbarkeit bzw. Schwenkbarkeit um die z1-Achse.

Die Anordnung der Stationärmagneten 22 auf einer gekrümmten Ebene kann einen erhöhten Schwenkwinkelbereich in zumindest einer Richtung des Transportkörpers 200 bieten. Beispielsweise kann ein zylinderförmiger Transportkörper 200, dessen gekrümmte Mantelfläche als Wirkfläche auf einem Stator 100 levitiert, gegebenenfalls eine Endlos-Drehung um seine Zylinderachse durchführen. Zusätzlich kann eine Endlos-Drehung um die z-Achse des Stators 100 möglich sein.

Durch eine in zwei Raumrichtungen gekrümmte Fläche kann beispielsweise der Schwenkwinkelbereich in zwei Raumrichtungen des Transportkörpers 200 erweitert werden. Beispielsweise kann gegebenenfalls ein mit Stationärmagneten 22 bestückter, kugelförmiger Transportkörper 200 Endlos-Drehungen in allen Raumrichtungen ausführen.

Der Transportkörper 200 kann auch als Zylinder- oder Kugelsegment, wie beispielsweise in den Figuren 4A und 4B gezeigt, ausgeführt sein, mit einer gekrümmten Seite, die mit Magneten bestückt ist, und einer Planseite, die zur Aufnahme eines Transportguts ausgebildet ist. Diese Anordnungen können beispielsweise die Möglichkeit bieten, einen Goniometertisch mit großem Schwenkwinkelbereich (beispielsweise 90 Grad) zu realisieren, der zusätzlich eine Drehung um die z1-Achse und bevorzugt eine Translation in allen Raumrichtungen ausführen kann. Diese Anordnung kann beispielsweise vorteilhaft in Bearbeitungsprozessen wie der Laserbearbeitung oder bei Prüfprozessen wie der industriellen Bildverarbeitung eingesetzt werden, da beispielsweise ein als Transportgut 20 eingesetztes Werkstück in weiten Bereichen frei unter einem Bearbeitungswerkzeug oder unter dem Prüfmittel positioniert und/oder orientiert werden kann. Zusätzlich können optional Werkstücke schnell in und aus einer Prozessposition transportiert werden, so dass eine oftmals wirtschaftlich ineffiziente Werkstück-Wechselzeit, in der der Prozess nicht genutzt werden kann, minimiert werden kann.

Figur 4C zeigt einen Transportkörper 200 gemäß einer weiteren bevorzugten Ausführungsform, bei welchem die Stationärmagneten 22 in einer winkelförmigen Anordnung angeordnet sind. Insbesondere weist der gezeigte Transportkörper 200 Stationärmagneten 22 auf, welche sich entlang eines ersten Schenkels waagrecht in die X1/Y1-Ebene erstrecken und entlang eines zweiten Schenkels in die X1/Z1-Ebene. Auf diese Weise kann ein Transportkörper 200 mit zwei Wirkflächen bereitgestellt werden, wie gezeigt beispielsweise mit einer waagrechten und einer senkrechten Wirkfläche, um beispielsweise zu verschiedenen Zeitpunkten oder gleichzeitig von verschiedenen angeordneten Statoren 100, beispielsweise von einem waagrecht angeordneten und einem senkrecht angeordneten Stator 100, levitiert bzw. befördert zu werden. Eine derartige Anordnung kann beispielsweise in einem Transportkörper 200 zum Einsatz kommen, der in laufendem Wechsel an unterschiedlich orientierten Wirkflächen betrieben wird. Beispielsweise kann ein Transportkörper 200 zwei im 90°-Winkel angeordnete Wirkflächen besitzen. Wenn dieser auf einer Anordnung von zwei Statoren betrieben wird, die ebenfalls im Winkel vom 90° zueinander angeordnet sind, wobei ein Stator 100 horizontal und der andere Stator 100 vertikal betrieben wird, kann beispielsweise ohne zwingende Unterbrechung vom Boden- in den Wandbetrieb gewechselt werden.

Ein Strukturbauteil bzw. Gehäuse bzw. Gerüst eines Transportkörper 200, welches beispielsweise die einzelnen Komponenten des Transportkörpers 200, wie etwa die Stationärmagneten 22 zusammenhält, ist vorzugsweise aus nicht-ferromagnetischem Material hergestellt, beispielsweise aus Kunststoff und/oder Keramik und/oder Nichteisenmetallen. Optional hat es ein nicht mit Magneten bestücktes Randelement 206, das beispielsweise als Abstandshalter zu anderen Transportkörper 200 dient, so dass vorzugsweise gegenseitige Kontaktkräfte zwischen zwei sich berührenden Transportkörpern 200 begrenzt werden und eine freie Positionierbarkeit beider Transportkörper 200 vorzugsweise auch bei deren Berührung nicht behindert wird.

Die Transportkörper 200 können an der dem Stator 100 zugewandten Seite hin mit einem unteren Deckelement 204 versehen sein, welches beispielsweise eine Deckschicht aufweist, die vorzugsweise als ein Distanzhalter zu möglichen Objekten im Umfeld des Transportkörpers 200 wirkt und vorzugsweise den Abstand und somit die maximalen Wirkkräfte der Stationärmagneten 22 sicher begrenzen kann. Dadurch kann beispielsweise eine Reduzierung der Verletzungsgefahr bei der Handhabung von Transportkörpern 200 erreicht werden, wie etwa die Gefahr von Quetschungen von Fingern bei unsachgemäßer Annäherung eines ferromagnetischen Gegenstands. Ferner kann vorzugsweise eine Überlastungs-Begrenzung für Antriebe bzw. Stellmagneten im Stator 100 erreicht werden, da die Kräfte und Momente, die der Transportkörpern 200 auf die Stellmagneten im Stator 100 ausübt, vorzugsweise begrenzt werden können. Darüber hinaus kann vorzugsweise eine bessere Reinigung der Transportkörper 200 von anhaftenden ferromagnetischen Partikeln erreicht werden, da die Haltekräfte geringer sind. Auch eine optionale Integration von Zusatzfunktionen in das untere Deckelement, wie beispielsweise eine Spule zur induktiven Energieübertragung oder ein Datenträger zur Identifikation des Transportkörpers 200, können dabei vorteilhaft sein.

Mehrere Transportkörper 200 können mechanisch und/oder steuerungstechnisch gekoppelt sein, um beispielsweise gemeinsam eine Funktion auszuführen. Beispielsweise kann eine passive mechanische Stabkinematik, deren Stäbe aktiv von separaten Transportkörpern 200 angetrieben und positioniert werden, Handhabungsaufgaben ausführen. In einem anderen Beispiel können mehrere Transportkörper 200 gemeinsam Lasten transportieren, die beispielsweise für einen einzelnen Transportkörper 200 zu schwer sind, indem sie vorzugsweise synchronisiert bewegt bzw. befördert werden.

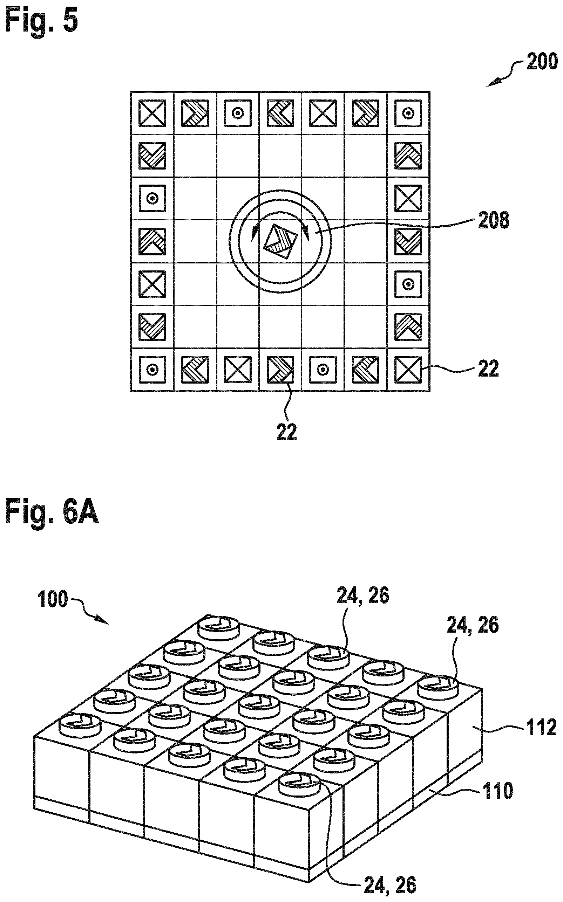

Ein Transportkörper 200 kann gemäß einer weiteren bevorzugten Ausführungsform auch innere Freiheitsgrade besitzen und beispielsweise aus mehreren relativ zueinander beweglichen Bauteilen bestehen, so dass er vorzugsweise insgesamt mehr als sechs Freiheitsgrade besitzt. Durch Bereitstellen von Stationärmagneten 22 in mehreren der Bauteile können vorzugsweise die mehr als sechs Freiheitsgrade des Transportkörpers 200 aktiv angesteuert werden. Wie in **Figur 5** dargestellt, kann beispielsweise eine im Transportkörper 200 drehbar gelagerte Scheibe 208 separat gedreht werden, um beispielsweise eine Zusatzfunktion auf dem Transportkörper 200 auszuführen, wie beispielsweise eine Greif- oder Spannfunktion für ein Transportgut 20.

Zudem kann ein Transportkörper 200 gemäß einer bevorzugten Ausführungsform mit Funktionsgruppen für weitere Zusatzfunktionen ausgerüstet sein. Beispielsweise kann eine mechanische Energieübertragung stattfinden, indem eine vorzugsweise drehbar gelagerte und mit Magneten bestückte Scheibe im Transportkörper 200 vom Stator 100 aktiv angetrieben wird. Zum Antrieb wird die Scheibe vom Stator 100 beispielsweise als siebter Freiheitsgrad behandelt. Auch kann optional eine elektrische, berührungslose Energieübertragung realisiert werden, indem beispielsweise im Stator 100 und im Transportkörper 200 jeweils Spulen zur induktiven Energieübertragung integriert werden. Alternativ oder zusätzlich kann beispielsweise ein permanent rotierender Magnet im Stator 100 eine Wechselspannung in einer Spule im Transportkörper 200 induzieren, die vorzugsweise zur Stromversorgung auf dem Transportkörper 200 genutzt werden kann. Bei einer Fortbewegung des Transportkörpers 200 wird die Aufgabe der Anregung der Zusatzfunktion fortwährend auf andere Magnetgruppen 24 bzw. Stellmagneten des Stators 100 übertragen, die beispielsweise in einem Wirkbereich der Induktionsspule liegen. Auch kann beispielsweise eine berührungslose Datenübertragung zwischen Stator 100 und Transportkörper 200, beispielsweise mit induktiven und/oder optischen Sendern und Empfängern, realisiert werden. Ferner kann optional eine Lokalisierung und/oder Identifizierung des Transportkörpers 200 vorgesehen sein. Beispielsweise kann ein optischer, kamerabasierter Sensor im Stator 100 einen Positions- oder Identifizierungscode, der auf der dem Stator 100 zugewandten Seite des Transportkörpers 200 angebracht ist, auslesen. Beispielsweise kann zumindest ein Teil der Transportkörper 200 mit einem Identifikationselement ausgestattet sein, wie etwa mit einem Strichcode, anhand dessen die Beförderungsvorrichtung 10 bzw. der Stator 100 den jeweiligen Transportkörper 200 identifizieren kann.

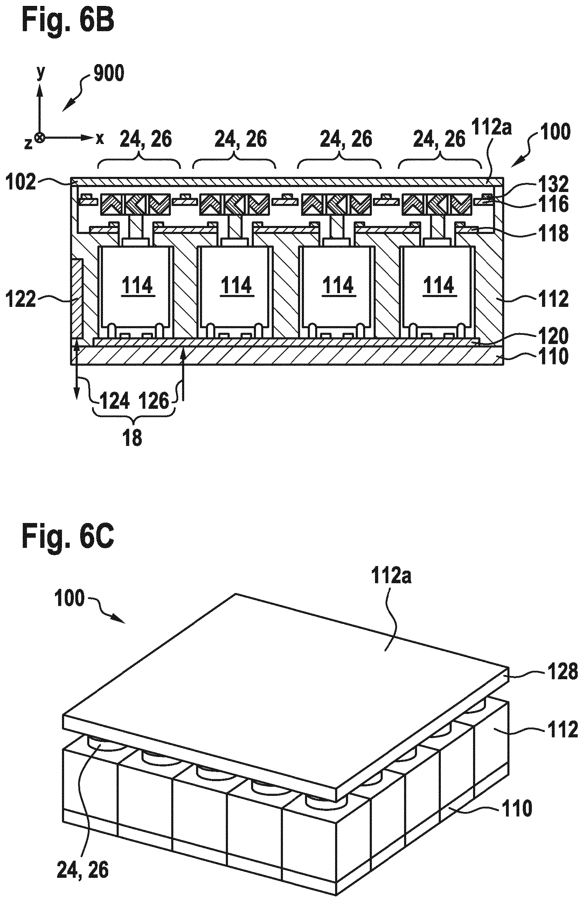

Die **Figuren 6A und 6B** zeigen in einer schematischen Darstellung einen Stator 100 gemäß einer bevorzugten Ausführungsform in einer perspektivischen Darstellung (Figur 6A) und in einer Querschnittsansicht (Figur 6B). Der Stator 100 weist dabei eine Vielzahl Stellmagneten 26 auf, welche jeweils wiederum eine Magnetgruppe 24 aufweisen, . Die Stellmagneten 26 sind zumindest teilweise von einem Strukturbauteil 112 eines Statorgehäuses umschlossen. Die Magnetgruppen 24 sind dabei gemäß der gezeigten bevorzugten Ausführungsform an einer Fläche bzw. Seite des Stators 100 angeordnet, welche in dem gezeigten Fall die Oberseite des Stators 100 ist. Wenngleich die Magnetgruppen 24 in der gezeigten Darstellung in Figur 6A alle gleich ausgerichtet sind, d.h. dass ihre gesamten bzw. effektiven DipolVektoren, die sich aus den einzelnen Dipol Vektoren der zur Magnetgruppe 24 gehörenden Magneten ergeben, parallel angeordnet sind, wird darauf hingewiesen, dass die Magnetgruppen 24 derart beweglich ausgebildet bzw. angeordnet sind, dass sie sich zumindest in ihrer Anordnungsebene relativ zum Statorgehäuse drehen können. Wenngleich in der Querschnittsansicht in Figur 6B lediglich drei Magneten in jeder Magnetgruppe in 24 gezeigt sind, können die Magnetgruppen 24 weniger oder mehr als drei Magneten aufweisen, die in einer ein-, zwei- oder dreidimensionalen Anordnung angeordnet sein können.

Die Stellmagneten 26 bzw. Magnetgruppen 24 sind mit Stellelementen 114 verbunden, mittels welcher Sie in Ihrer Position und/oder Orientierung geändert werden können. Ein Stellelement 114 weist dabei beispielsweise mindestens einen Antrieb, wie etwa einen Elektromotor auf, welcher vorzugsweise über eine Antriebswelle und/oder ein Getriebe und/oder ein Gestänge mit der Magnetgruppe 24 verbunden ist.

Die benötigten Magnetfelder zur Führung des mindestens einen Transportkörpers 200 werden durch eine kontrollierte, beispielsweise geregelte Bewegung, der Magnetgruppen 24 bzw. Stellmagneten 26 in dem Stator 100 erzeugt. Das von den Magnetgruppen 24 erzeugte Magnetfeld tritt zumindest teilweise aus der Wirkfläche 102 des Stators 100 aus und übt auf die Stationärmagneten 22 im Transportkörper 200 Kräfte und/oder Momente aus. Die Richtung und Stärke der Kräfte und/oder Momente im Transportkörper 200 wird durch die Lage bzw. Orientierung der Stellmagneten 26 bzw. Magnetgruppen 24 im Stator 100 beeinflusst. Die Lage der Stellmagneten 26 bzw. Magnetgruppen 24 im Stator 100 wird dabei vorzugsweise so geregelt, dass der Transportkörper 200 schwebt und entsprechend einer vorgegebenen Sollkurve in allen sechs Dimensionen geführt oder an einer vorgegebenen Sollposition mit einer vorgegebenen Sollorientierung stabil gehalten wird.

Wie in Figur 6B gezeigt, weist der Stator 100 eine Anordnung von beweglichen Stellmagneten 26 auf. Stellelemente 114 können die Orientierung und/oder Position der Magnetgruppen 24 bzw. der Stellmagneten 26 entsprechend einer Sollvorgabe ändern. Ein Transportkörperpositionsbestimmungselement 116 ist dazu eingerichtet, eine Ist-Position aller auf dem Stator 100 beförderten Transportkörper 200 bzw. aller Transportkörper im Einflussbereich des jeweiligen Stators 100 zu bestimmen. Beispielsweise kann das Transportkörperpositionsbestimmungselement 116 eine Sensorschicht und/oder eine Leiterplatte mit Sensoren aufweisen. Ein Steuerungselement 122 kann vorzugsweise die von dem Transportkörperpositionsbestimmungselement 116 bereitgestellten Sensorsignale auswerten und diese beispielsweise einer übergeordneten Anlage bereitstellen. Die Stellelemente 114 können beispielsweise über eine Leiterplatte 120 kontaktiert werden.

Ferner weist der Stator 100 gemäß der gezeigten, bevorzugten Ausführungsform ein Magnetstellungsbestimmungselement 118 auf, mittels welchem die tatsächlich vorliegende Position und/oder Orientierung der Magnetgruppen 24 bzw. der Stellmagneten 26 ermittelt werden kann. Beispielsweise kann das Magnetstellungsbestimmungselement 118 eine Sensorschicht aufweisen.

Die Anordnung der Magnetgruppen 24 im Stator 100 ist vorzugsweise eben, d.h. dass vorzugsweise alle Magnetgruppen 24 in einer Ebene angeordnet sind.

Die **Figuren 6C und 6D** zeigen einen Stator 100 gemäß einer weiteren bevorzugten Ausführungsform, welcher ähnlich zur in Figur 6A und 6B gezeigten Ausführungsform ist und zusätzlich eine Abdeckung 112a und eine optionale Spulenschicht 128 aufweist. Die Abdeckung 112a ist vorzugsweise aus nicht-ferromagnetischen Materialien gefertigt. Das von den Magnetgruppen 24 ausgehende Magnetfeld tritt durch die Abdeckung 112a nach außen, welche beispielsweise zumindest teilweise aus Kunststoff und/oder nichtmagnetischem Metall und/oder Keramik und/oder Glas gefertigt ist. Die Abdeckung 112a kann beispielsweise das Innere des Stators 100 gegen den Arbeitsraum der Transportkörper 200 abschirmen und somit ein Eindringen und/oder Austreten von Partikeln verhindern. Ferner kann die Abdeckung 112a dazu dienen, die maximalen Wirkkräfte der Stellmagneten 26 im Stator 100 auf Objekte außerhalb des Stators 100 sicher zu begrenzen. Dabei kann der Abstand derart ausgelegt sein, dass ein auf der Abdeckung 112a aufliegender Transportkörper 200 vorzugsweise nicht zu einer Blockade der Stellelemente 114 führt. Zusätzlich wird vorzugsweise eine Anziehungskraft auf ferromagnetische Teile, die nicht bestimmungsgemäß auf der Abdeckung 112a abgelegt werden, begrenzt, so dass diese leicht wieder ablösbar sind und nicht zu Verletzungen bei der Handhabung führen.

Die Spulenschicht 128 kann beispielsweise als eine Mehrlagen-Leiterplatte mit innenliegenden Spulen ausgebildet sein.

Die dem zumindest einen Transportkörper 200 zugewandte Oberfläche der Abdeckung 112a bildet vorzugsweise die Wirkfläche 102 des Stators 100. Optional kann eine mechanische Rückzugsvorrichtung vorgesehen sein (nicht gezeigt), die den Abstand aller Magnetgruppen 24 der Stellmagneten 26 von der Wirkfläche 102 vergrößert. Die Rückzugsvorrichtung kann beispielsweise bei Stillstand der Beförderungsvorrichtung 10 automatisch aktiviert werden, damit die im Stillstand aus der Wirkfläche 102 austretenden Magnetfelder sicher begrenzt werden. So kann beispielsweise ein gefahrloses Hantieren vor der Wirkfläche 102 ermöglicht und eine Reinigung von anhaftenden ferromagnetischen Partikeln erleichtert werden.

Der Stator 100 kann vorzugsweise in beliebiger Richtung zur Schwerkraft betrieben werden, beispielsweise im Tischbetrieb (Transportkörper 200 schwebt über der Wirkfläche 102), im Wandbetrieb (Transportkörper 200 schwebt neben der Wirkfläche 102) oder Deckenbetrieb (Transportkörper 200 schwebt unter der Wirkfläche 102). Auch ein Betrieb des Gesamtsystems in einem beschleunigten Bezugssystem oder unter Schwerelosigkeit ist prinzipiell möglich.

Vorzugsweise ist der Stator 100 modular aufgebaut, so dass mehrere gleichartige und/oder unterschiedliche Stator-Module auf einfache Weise vorzugsweise nahtlos aneinandergereiht werden können (siehe Figur 1D). Die Stator-Module sind vorzugsweise mit Datenverbindungen 124 ausgestattet, beispielsweise mit Kommunikationskanälen, so dass Informationen über die Zustände des Stators 100 sowie der darauf befindlichen Transportkörper 200 vorzugsweise in Echtzeit übertragen werden können.

Die Transportkörper 200 können vorzugsweise frei von einem Stator-Modul auf ein anderes Stator-Modul hinübergleiten. So kann vorzugsweise ein Arbeitsbereich der Transportkörper 200 nach Bedarf erweitert werden. Jedes Modul hat ferner vorzugsweise eine Schnittstelle zur Energieversorgung 126 und mechanische Schnittstellen zur Kopplung mit weiteren Stator-Modulen und zur einfachen Integration in eine Anlage.

Das Magnetfeld des Stators 100 wird vorzugsweise durch eine vorwiegend flächige bzw. ebene Anordnung der Magnetgruppen 24 erzeugt. Die Anordnung der Magnetgruppen 24 bildet bevorzugt ein regelmäßiges quadratisches Raster von Magnetgruppen 24, jedoch sind auch andere regelmäßige oder unregelmäßige Anordnungen möglich.

Die **Figuren 7A bis 7E** zeigen beispielhafte Anordnungen von Magnetgruppen 24 bzw. Stellmagneten 26. Beispielsweise zeigt Figur 7A eine Anordnung der Magnetgruppen 24 gemäß einem rechteckigen, insbesondere quadratischen Raster. Figur 7B zeigt eine Anordnung der Magnetgruppen 24 gemäß einem hexagonalen Raster. Figur 7C zeigt eine beispielhafte Anordnung unterschiedlicher Magnetgruppen 24 gemäß einem rechteckigen Raster. Beispielsweise können sich die Magnetgruppen in ihrem magnetischen Dipolmoment unterscheiden. Ferner können auch manche der Magnetgruppen schnell- oder langsamdrehend sein, über unterschiedliche Getriebe mit dem Antrieb verbunden sein und/oder mit unterschiedlichen Antrieben betrieben werden. Anordnungen gemäß den Figuren 7A bis 7C sind besonders dann vorteilhaft, wenn es beabsichtigt ist, dass die Drehachsen im Wesentlichen senkrecht zur Anordnungsebene liegen. Ferner zeigen Figuren 7D und 7E Anordnungen, bei denen die Magnetgruppen über Antriebswellen 28 mit den Antrieben verbunden sind, wobei die Antriebswellen im Wesentlichen parallel zur Wirkfläche 102 verlaufen. Gemäß der Anordnung Figur 7D verlaufen die Antriebswellen 28 parallel, gemäß der Anordnung in Figur 7E zumindest annähernd radial bzw. zirkular.

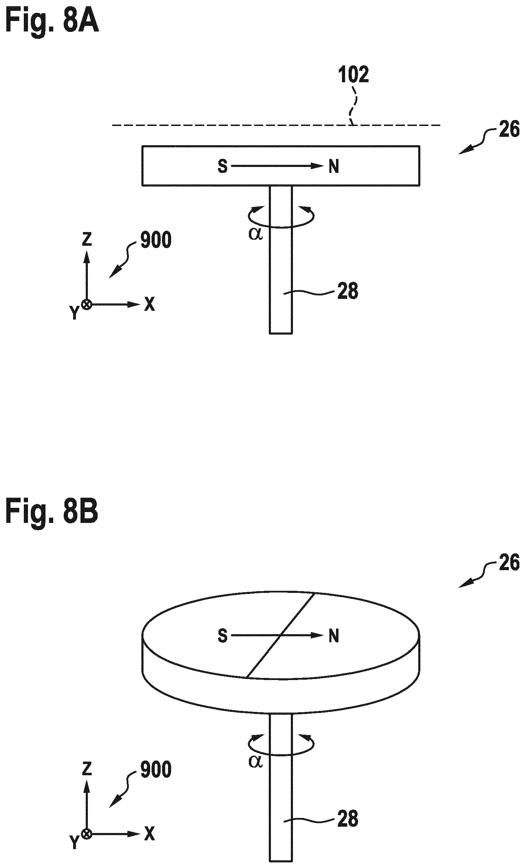

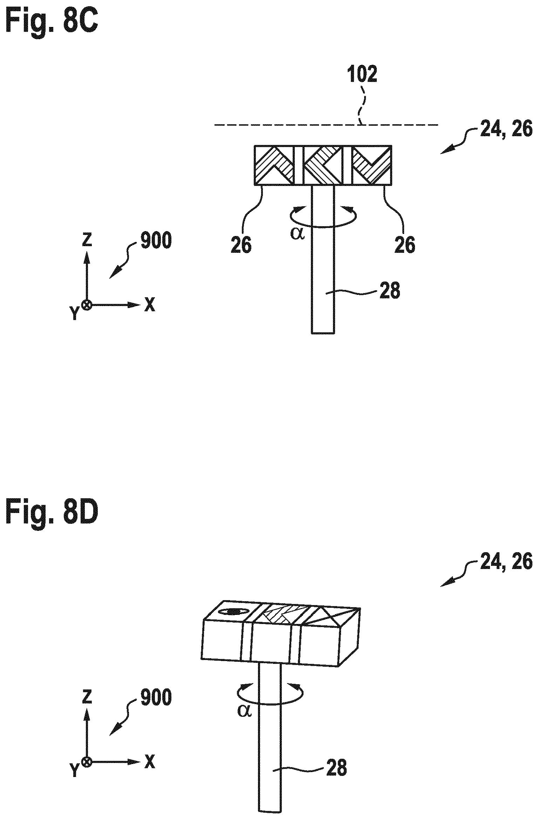

Ein Stellmagnet 26 wird gemäß einer bevorzugten Ausführungsform durch einen einzelnen Magneten gebildet, wie in den **Figur 8A und 8B** dargestellt, alternativ durch eine Anordnung von mehreren Magneten in einer Magnetgruppe 24, wobei die Magneten vorzugsweise mechanisch fest miteinander verbundenen sind, wie in den **Figuren 8C und 8D** dargestellt. Alternativ kann ein Stellmagnet 26 durch eine Magnetgruppe 24 gebildet werden, die mehrere unterschiedlich magnetisierte Bereiche besitzt. Vorzugsweise bildet die Magnetgruppe 24 ein Halbach-Array (siehe Figuren 8C und 8D), welches in Richtung der Wirkfläche orientiert ist. Das bietet den Vorteil, dass die Flussdichte in Richtung der Wirkfläche 102 vergrößert und in allen anderen Richtungen verringert wird, insbesondere in Richtung benachbarter Magnetgruppen 24. Die in den Figuren 8A bis 8D dargestellten Stellmagneten 26 bzw. Magnetgruppen 24 sind dabei derart mit der Antriebswelle 28 verbunden, dass die Drehachse des Antriebs senkrecht zur Wirkfläche 102 steht. Der Winkel a bezeichnet dabei den Stellwinkel der Antriebswelle 28 bzw. des Stellmagneten 26 bzw. der Magnetgruppe 24.

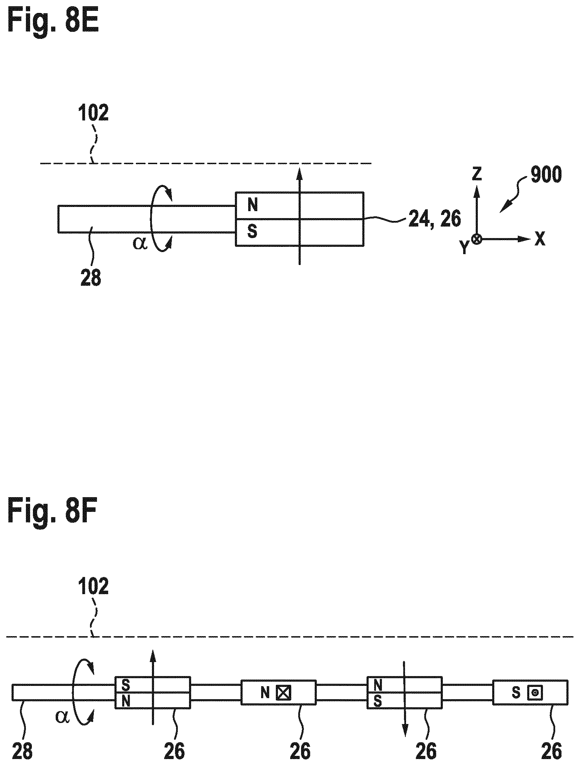

Die **Figuren 8E und 8F** zeigen Anordnungen, bei welchen die Stellmagneten 26 bzw. die Magnetgruppen 24 derart mit der jeweiligen Antriebswelle 28 verbunden sind, dass die Antriebswellen 28 im Wesentlichen parallel zur Wirkfläche 102 verlaufen. Bei derartigen Anordnungen erfolgt daher eine Drehung der Stellmagneten 26 bzw. der Magnetgruppen 24 um die X-Achse 902.

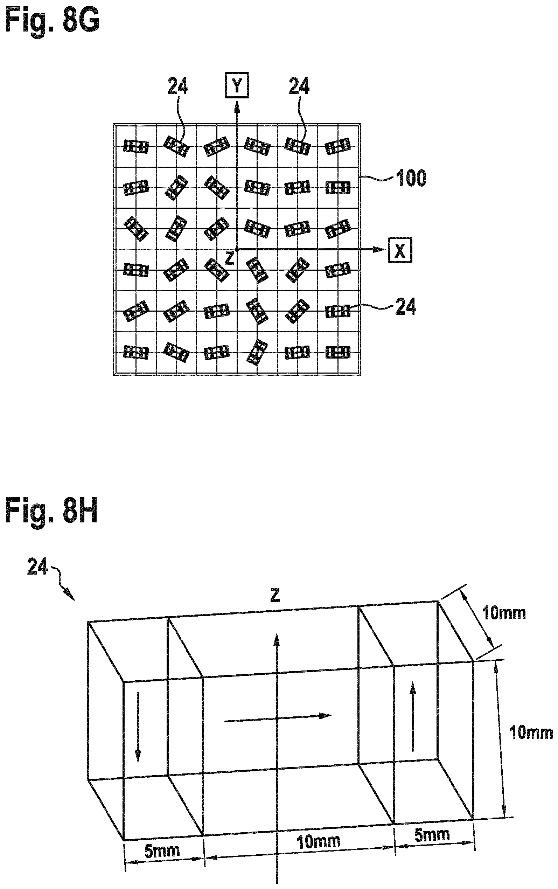

**Figur 8G** zeigt schematisch eine Anordnung gemäß einer bevorzugten Ausführungsform von 6 x 6 Magnetgruppen 24 gemäß einem quadratischen Raster in einem Stator 100, wobei die Magnetgruppen 24 jeweils als ein Halbach-Array ausgeführt sind. Eine detaillierte Darstellung einer einzelnen Magnetgruppe 24, insbesondere mit typischen Abmessungen gemäß einer bevorzugten Ausführungsform einer derartigen Magnetgruppe 24, ist in **Figur 8H** gezeigt.

Die Magnetgruppen 24 sind vorzugsweise im Stator 100 einzeln verstellbar, sie können also in ihrer Position und/oder Orientierung verändert werden. Sie können vorzugsweise eine Linearbewegung und/oder eine Drehung und/oder eine überlagerte Bewegung ausführen. Vorzugsweise wird eine Drehung um eine baulich fest vorgegebene Drehachse der Antriebswelle 28 ausgeführt. Um durch die Drehung eine wirksame Änderung des Magnetfeldes zu erreichen, ist der dominierende Dipolvektor der Magnetgruppe 24 vorzugsweise senkrecht zur Drehachse der Antriebswelle 28 orientiert.

Die Drehachsen der Magnetgruppen 24 können in Bezug auf die Wirkfläche 102 unterschiedlich orientiert sein. Vorzugsweise sind sie senkrecht und/oder parallel zur Wirkfläche 102 orientiert. Der Abstand benachbarter Magnetgruppen 24 ist so gewählt, dass die Drehmomente auf die Magnetgruppen 24, die durch ihre magnetische Wechselwirkung verursacht werden, gering sind im Verhältnis zu den typischen Drehmomenten, die durch die Transportkörper 200 verursacht werden.

Zur Positionierung und/oder Orientierung der Magnetgruppen 24 werden Stellelemente 114 eingesetzt, die bevorzugt Linearbewegungen und/oder Drehungen und/oder überlagerte Bewegungen ausführen können. Ein Stellelement 114 bewegt vorzugsweise mindestens eine Magnetgruppe 24. Vorzugsweise werden Stellelemente 114 eingesetzt, die einen Winkelbereich von 360° abdecken können und vorzugsweise in der Lage sind, endlose Drehungen auszuführen. Dies kann für viele Bewegungen des Transportkörpers 200 vorteilhaft sein.

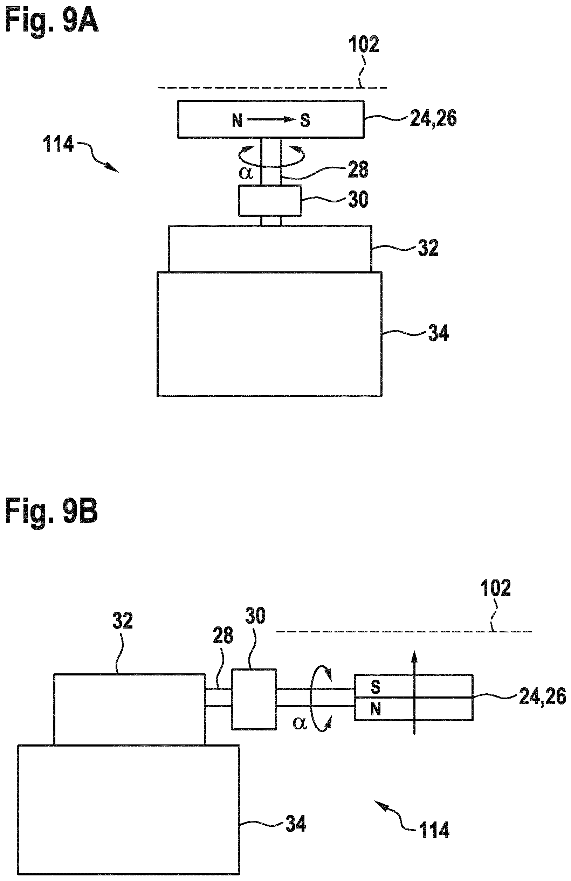

Die **Figuren 9A und 9B** zeigen in schematischen Darstellungen bevorzugte Ausführungs-formen von Stellelementen 114. Bevorzugt weisen diese einen Antrieb auf, welcher beispielsweise einen Motor 34, wie etwa einen Elektromotor, aufweist, welcher optional über ein Getriebe 32 und die Antriebswelle 28 mit dem Stellmagneten 26 bzw. der Magnetgruppe 24 mechanisch verbunden bzw. gekoppelt ist. Vorzugsweise weist das Stellelement 114 einen Sensor 30 zur Ermittlung des Stellwinkels a auf und optional einen Regler (nicht gezeigt), der den Stellwinkel a vorzugsweise schnell und präzise auf eine vorgegebene Sollposition einstellen bzw. nachführen kann.

Beispielsweise weist ein Stellelement 114 einen Elektromotor auf, auf dessen Achse mindestens eine Magnetgruppe 24 montiert ist. Der Sensor 30 misst den Drehwinkel a der Antriebswelle, ein PID-Regler mit optional nachgeschaltetem Antriebsverstärker steuert vorzugsweise den Motor 34 an. Zur Erhöhung des Drehmomentes oder der Drehzahl kann ein Getriebe 32 zwischen dem Motor 34 und der Antriebswelle 28 vorgesehen sein. Das Getriebe 32 kann beispielsweise selbsthemmend sein, so dass der Motor 34 zur Aufrechterhaltung eines Drehmomentes in einer konstanten Winkelstellung nicht mit Strom versorgt werden muss.

Die in den Figuren 7A bis 7E gezeigten beispielhaften, ebenen Anordnungen von gleichartigen Magnetgruppen 24 in einem regelmäßigen Raster werden dabei vorzugsweise derart ausgestaltet, dass jede der Magnetgruppen 24 von einem separaten Stellelement 114 angetrieben bzw. bewegt werden kann. Dabei können beispielsweise die in Figur 7C dargestellten großen und kleinen Magnetgruppen 24 von unterschiedlichen Stellelementen 114 angetrieben werden, wobei beispielsweise große Magnetgruppen 24 von Stellelementen 114 mit hohem Drehmoment und großer Trägheit (beispielsweise mit Getriebe) angesteuert werden, während kleine Magnetgruppen 24 von Stellelementen 114 mit geringerem Drehmoment und geringerer Trägheit angesteuert werden. Figur 7D zeigt eine beispielhafte Anordnung, bei der die Antriebswellen 28 parallel zur Wirkfläche 102 verlaufen und vorzugsweise jede Antriebswelle 28 mehrere Magnetgruppen 24 antreibt.

Ein Stellelement 114 mit mehreren Antrieben kann vorzugsweise mehrere Freiheitsgrade einer Magnetgruppe 24 beeinflussen. Beispielsweise kann eine kardanisch in zwei Raumrichtungen drehbar gelagerte Magnetgruppe 24 von zwei Stellelementen 114 in zwei unterschiedlichen Raumrichtungen gedreht werden.

Anstelle von Elektromotoren können auch andere Antriebssysteme eingesetzt werden, beispielsweise ein Hubmagnet oder ein Piezoantrieb.

Zur Erzielung einer hohen Dynamik kann es vorteilhaft sein, die Magnetgruppen 24 um eine ihrer Haupt-Trägheitsachsen mit geringem Trägheitsmoment zu drehen. Die Drehachse läuft vorzugsweise durch den Schwerpunkt der jeweiligen Magnetgruppe 24, um Vibrationen des Stators 100 aufgrund von Unwucht zu vermeiden. Um die Trägheit der mechanischen Antriebe zu kompensieren, können beispielsweise unterhalb der Wirkfläche 102 zusätzlich Spulen (siehe Figuren 6c und 6D) eingesetzt werden, die beispielsweise mit hoher Dynamik verhältnismäßig kleine Korrekturkräfte und/oder -momente auf den Transportkörper 200 ausüben können. Das Wirkfeld bzw. Levitationsfeld 14 bzw. Magnetfeld des Stators 100 ergibt sich dann aus einer Überlagerung der Stellmagnet-Felder und der Spulen-Felder, wobei die Spulenfelder zwar gegebenenfalls deutlich schwächer, aber schneller veränderbar sein können.

Da sich die Antriebe sowie die Antriebsverstärker im Betrieb erwärmen können, kann eine Kühlvorrichtung vorgesehen werden, die beispielsweise durch Wärmeableitung über einen Kühlkörper oder eine Lüftung und geeignete Lüftungskanäle im Stator 100 die Antriebe und/oder Antriebsverstärker kühlt (siehe beispielsweise Figur 6B).

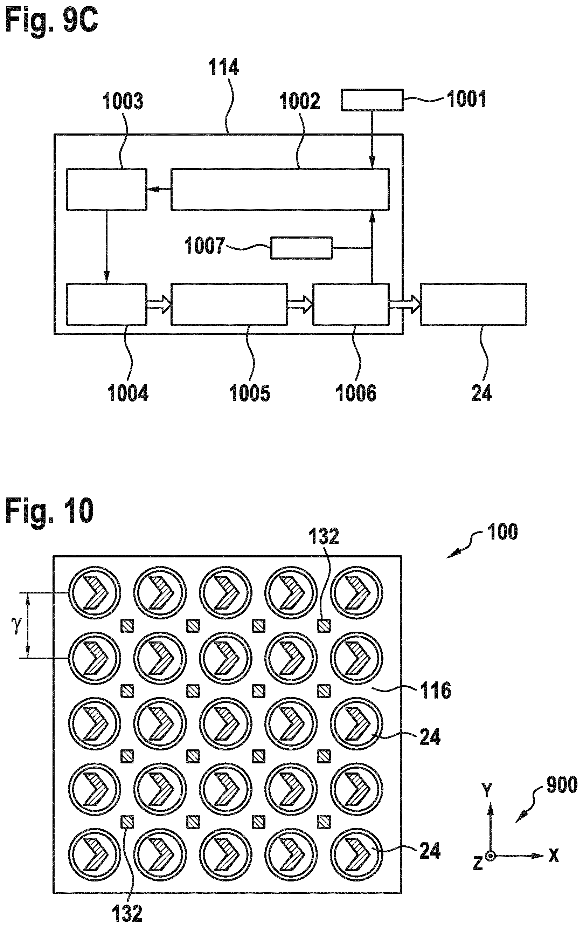

**Figur 9C** zeigt in einem Blockdiagramm ein beispielhaftes Funktionsprinzip eines Stellelements 114. Dabei wird beispielsweise einem Regler 1002 eine Soll-Position 1001 der jeweiligen Magnetgruppe 24 übermittelt. Über einen Antriebsverstärker 1003 kann sodann der Antrieb 1004 derart angesteuert werden, dass die Magnetgruppe 24 ggf. über ein Getriebe 1005 entsprechend angesteuert wird. Über einen entsprechenden Sensor 1006 kann die tatsächliche Winkellage bzw. die Ist-Position 1007 der Magnetgruppe 24 ermittelt werden und wieder dem Lageregler zugeführt werden, so dass ein Regelkreis entsteht, mittels welchem eine möglichst genaue Positionierung und/oder Orientierung der Magnetgruppe erfolgen kann.

Gemäß einer weiteren bevorzugten Ausführungsform weist die Beförderungsvorrichtung eine Positionsbestimmungseinheit auf. Diese ist vorzugsweise derart eingerichtet, dass die Position und/oder Orientierung des zumindest einen Transportkörpers 200 relativ zur Wirkfläche des Stators 100 erfasst werden kann, vorzugsweise zyklisch, besonders bevorzugt mit hoher Frequenz und geringer Latenzzeit. Vorzugsweise werden dabei alle Freiheitsgrade des Transportkörpers 200 erfasst. Eine Messung kann beispielsweise die Basis für die Regelung der Transportkörper-Position darstellen. **Figur 10** zeigt eine bevorzugte Ausführungsform einer Positionsbestimmungseinheit, welche ein Transportkörperpositionsbestimmungselement 116 aufweist. Beispielsweise kann das Transportkörperpositionsbestimmungselement 116 als Leiterplatte ausgestaltet sein, welches vorzugsweise Aussparungen für die Magnetgruppen 24 bzw. die Stellmagneten 26 aufweist und/oder mit Sensoren 132 bestückt ist, wobei die Sensoren 132 vorzugsweise als Magnetfeldsensoren ausgebildet sind.

Die Positionsbestimmungseinheit kann zumindest teilweise in den Stator 100 integriert sein oder räumlich getrennt vom Stator 100 installiert sein und die Positionsdaten an eine Stator-Regelung übertragen. Vorzugsweise ist die Positionsbestimmungseinheit jedoch im Stator 100 integriert, wodurch vorzugsweise ein konstanter Maßbezug zum Stator 100 gewährleistet werden kann und/oder die Handhabung des Gesamtsystems vereinfacht wird. Bei Integration in den Stator 100 kann beispielsweise auch der vorhandene Bauraum effizient genutzt werden, da die Positionsbestimmung auf der Seite des Transportkörpers 200 erfolgt, die dem Stator 100 zugewandt ist, und somit vorzugsweise die Positionsbestimmung nicht durch das Transportgut behindert oder verfälscht wird.

Als Sensoren 132 werden bevorzugt Magnetfeldsensoren und/oder kapazitive Sensoren und/oder optische Sensoren eingesetzt. Die Sensoren werden bevorzugt in einem regelmäßigen Raster unterhalb der Wirkfläche 102 angeordnet. Beispielsweise können Hall-Sensoren das Magnetfeld im Transportkörper 200 an mehreren Stellen und/oder in unterschiedlichen Raumrichtungen erfassen. Vorzugsweise werden alle Sensorsignale zur Auswertung an ein Rechnersystem übertragen. Dort kann beispielsweise mittels eines Algorithmus die Ist-Position des Transportkörpers 200 aus den Sensor-Signalen und einer modellhaften Beschreibung der Magnetanordnungen in Transportkörper 200 und Stator 100 ermittelt werden.

Um den Einfluss der Magnetfelder im Stator 100 auf die Positionsbestimmung des Transportkörpers 200 zu reduzieren oder zu eliminieren, werden die Sensoren 132 vorzugsweise in möglichst großem Abstand zu den Magnetgruppen 24 des Stators 100 montiert. Zusätzlich können magnetische Abschirmvorrichtungen vorhanden sein, welche den Einfluss der Magnetgruppen 24 auf die als Magnetfeldsensoren ausgebildeten Sensoren 132 abschwächen. Beispielsweise kann in einem einmaligen automatischen Kalibriervorgang ohne Anwesenheit des Transportkörpers das Sensor-Signal aller Sensoren 132 in Abhängigkeit von der Position jeder einzelnen Magnetgruppe 24 gemessen werden, wobei die Messwerte als Korrekturtabelle dauerhaft in einem Speicher des Rechnersystems abgelegt werden können. Im Betrieb können beispielsweise die Sensor-Rohwerte nach jeder Messung um die in der Korrekturtabelle abgelegten Fehlbeträge aller Magnetgruppen - abhängig von deren aktueller Position - korrigiert werden.

Gemäß einer weiteren bevorzugten Ausführungsform stellt eine Bedienschnittstelle im Stator 100 grundlegende Bedien- und Anzeigeelemente für die Einrichtung und/oder den Betrieb und/oder den Service und/oder die Wartung bereit. Beispielsweise können Ein-/Aus-Schalter, Rücksetztaster sowie Signallampen für die Anzeige des Betriebs- oder Fehlerzustandes des Stators 100 vorhanden sein. Komplexere Einrichtfunktionen sind vorzugsweise von einem übergeordneten Rechnersystem aus bedienbar, das beispielsweise über eine Kommunikationsschnittstelle mit dem Stator 100 verbunden ist.

Vorzugsweise erfasst eine elektronische Steuerung mit mindestens einem Rechnersystem die Sensorsignale, kommuniziert mit der übergeordneten Anlage, mit der Bedienerschnittstelle und ggf. mit weiteren Statoren und Systemkomponenten und steuert die Stellelemente an.

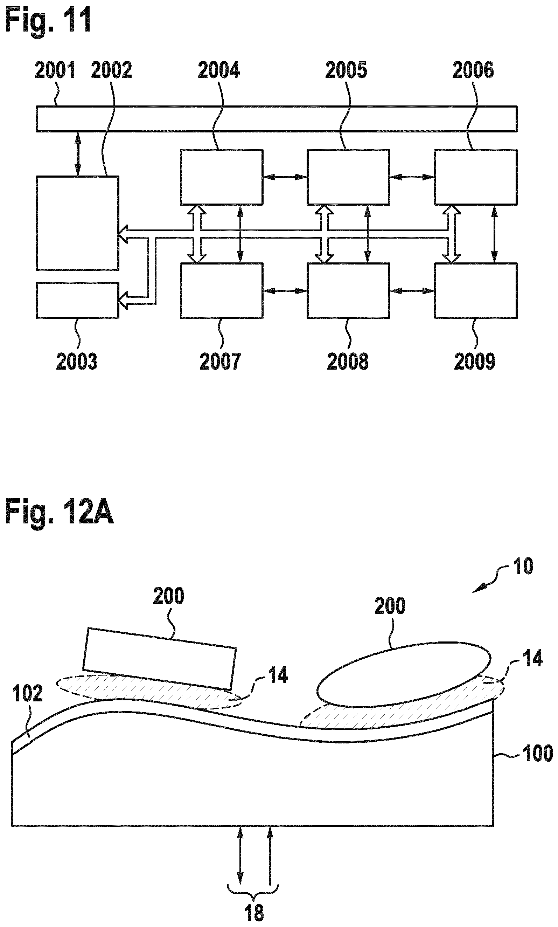

Vorzugsweise ist in jeden Stator 100 bzw. in jedes Statormodul ein Rechnersystem integriert. Bei Verwendung mehrerer Statoren 100 bzw. Statormodulen können deren Rechnersysteme beispielsweise mit Bussystemen vernetzt sein, deren Topologie flexibel erweitert werden kann. Ein beispielhaftes Steuerungsdiagramm ist in **Figur 11** dargestellt, welches die folgenden Elemente aufweist:

    2001: Steuerung einer übergeordneten Anlage
    2002: Zentralsteuerung der Beförderungsvorrichtung
    2003: Bedienerschnittstelle
    2004: Modulsteuerung Stator 1
    2005: Modulsteuerung Stator 2
    2006: Modulsteuerung Stator 3
    2007: Modulsteuerung Stator 4
    2008: Modulsteuerung Stator 5
    2009: Modulsteuerung Stator 6

Die Bussysteme sind in der Lage, große Datenmengen in kurzer Zeit ohne Latenz zu übertragen. Die Bussysteme können die Daten auf elektrische, optische und/oder induktive Weise übertragen. Beispielsweise können benachbarte Statoren 100 bzw. Statormodule optische Sender und Empfänger besitzen, über die sie Zustandsinformationen austauschen. In die Bussysteme können weitere Rechnersysteme integriert sein.

Gemäß einer bevorzugten Ausführungsform kann das Verfahren zum Betrieb der Beförderungsvorrichtung 10 in Form von Algorithmen auf dem mindestens einen Rechnersystem implementiert sein. Ein Verbund von mehreren Statoren 100 kann dabei als funktionale Einheit behandelt werden, so dass die Steuerung eines Transportkörpers 200 unabhängig davon erfolgt, ob er sich im Einflussbereich nur eines Stators 100 oder mehrerer Statoren 100 befindet. Dazu sind die Rechnersysteme bevorzugt auf eine gemeinsame Zeitbasis synchronisiert.

Das mindestens eine Rechnersystem stellt vorzugsweise alle Funktionen bereit, die für die Einrichtung und/oder den sicheren Betrieb und/oder für Service und Wartung jedes Stators 100 und eines Verbundes von mehreren Statoren 100 erforderlich sind. Beispielsweise können integrierte Eigendiagnosefunktionen permanent die korrekte Funktion überwachen, so dass eine Fehlfunktion sofort erkannt und gemeldet werden kann und/oder Ersatzmaßnahmen getroffen werden können und das System ggf. selbsttätig in den sicheren Not-Halt gehen kann.

Eine erfindungsgemäße Beförderungsvorrichtung 10 weist mindestens einen Stator 100 bzw. mindestens ein Statormodul und mindestens einen Transportkörper 200 auf. Dabei sind vorzugsweise viele Gestaltungsparameter vorhanden, die zur Anpassung an eine Zielapplikation beeinflusst werden können, z.B. Abmessungen des Stators 100 zur Skalierung auf die Größe bzw. das Gewicht des Transportgutes, ein maximales Drehmoment und/oder Drehzahl und/oder Trägheitsmoment der Antriebe, eine Stärke und/oder Anordnung der Stellmagneten 26 und Stationärmagneten in Stator 100 bzw. Transportkörper 200, sowie Regelungsparameter.

Die Anordnung der Magnetgruppen 24 im Stator 100 ist vorzugsweise derart auf die Anordnung der Magnetgruppen 24 im Transportkörper 200 abgestimmt, dass ein Transportkörper 200 mit f Freiheitsgraden an jedem Punkt seines Arbeitsraumes von den Kräften und Momenten von mindestens f Magnetgruppen 24 beeinflusst werden kann. Insbesondere sind die Magnetanordnungen so gestaltet, dass es keine Singularitäten gibt, also keine singulären Bereiche im Arbeitsraum, an denen diese Bedingung nicht erfüllt ist. Beispielhafte Paarungen von Magnetanordnungen in Stator und Transportkörper sind wie folgt:

- Stator wie Figur 7A und Transportkörper wie Figur 3F mit $\gamma / \lambda = 1 / 3$.
- Stator wie Figur 7A und Transportkörper wie Figur 3G mit $\gamma / \lambda = 1 / 3$.
- Stator wie Figur 7A und Transportkörper wie Figur 3I mit $\gamma / \lambda = 1 / 3$.
- Stator wie Figur 7A und Transportkörper wie Figur 3M mit $\gamma / 2r = 1 / 3$.
- Stator wie Figur 7B und Transportkörper wie Figur 3F mit $\gamma / \lambda = 1 / 3$.
- Stator wie Figur 7E und Transportkörper wie Figur 3I mit $R / r = 1$.

Während $\lambda$ die Periodenlänge einer Halbach-Anordnung von Stationärmagneten 22 bzw. Magnetgruppen 24 von Stationärmagneten 22 bezeichnet, bezeichnet $\gamma$ eine Periodenlänge einer regelmäßigen Anordnung von Stellmagneten 26 bzw. Magnetgruppen 24 (siehe beispielsweise Figur 7A).

Vorzugsweise sind die Transportkörper 200 überbestimmt, d.h. sie können von mehr als f Magnetgruppen 24 simultan beeinflusst werden. Die so erzielte Redundanz hat Vorteile, wie etwa eine verbesserte Ausfallsicherheit. Falls eine Magnetgruppe 24 nicht mehr wirksam steuerbar ist, kompensieren vorzugsweise andere Magnetgruppen 24 den Ausfall zumindest teilweise, so dass die Position des Transportkörpers 200 ggf. mit Einschränkungen eingehalten werden kann. Die für eine Kraft-/Moment-Änderung erforderliche Positionsänderung kann vorzugsweise auf mehrere Magnetgruppen 24 verteilt werden. Dadurch verringert sich vorzugsweise die Positionsänderung für jede einzelne Magnetgruppe 24. Daher kann vorzugsweise die Positionsänderung insgesamt schneller ausgeführt werden, so dass die Dynamik der Beförderungsvorrichtung 10 zunimmt. Vorzugsweise verteilen sich die zur Führung eines Transportkörpers 200 aufzubringenden Kräfte und Momente auf mehrere Magnetgruppen 24, so dass kleinere Magnetgruppen 24 mit schwächeren Stellelementen 114 eingesetzt werden können, um die gleiche Wirkung zu erzielen. Dies kann Vorteile für den Energieverbrauch und die Kosten der Beförderungsvorrichtung 10 bringen.

Die Beförderungsvorrichtung kann vorzugsweise mit klassischen Transfersystemen kombiniert werden. Beispielsweise können die Transportkörper 200 über große Entfernungen mit einem Gurtband transportiert werden, indem sie beispielsweise einen Stator 100 verlassen, von einem Gurtband zu einer neuen Position gefahren werden, und dort wieder auf einen Stator auffahren bzw. aufgesetzt werden. Im Rahmen eines modularen Gesamtsystems können Statoren 100 mit unterschiedlichen Fähigkeiten kombiniert werden. Beispielsweise kann es Stator-Module geben, die auf hohe Geschwindigkeit und/oder hohe Präzision und/oder hohe Kräfte optimiert sind. Diese Module werden vorzugsweise bereichsweise dort eingesetzt, wo sie benötigt werden.

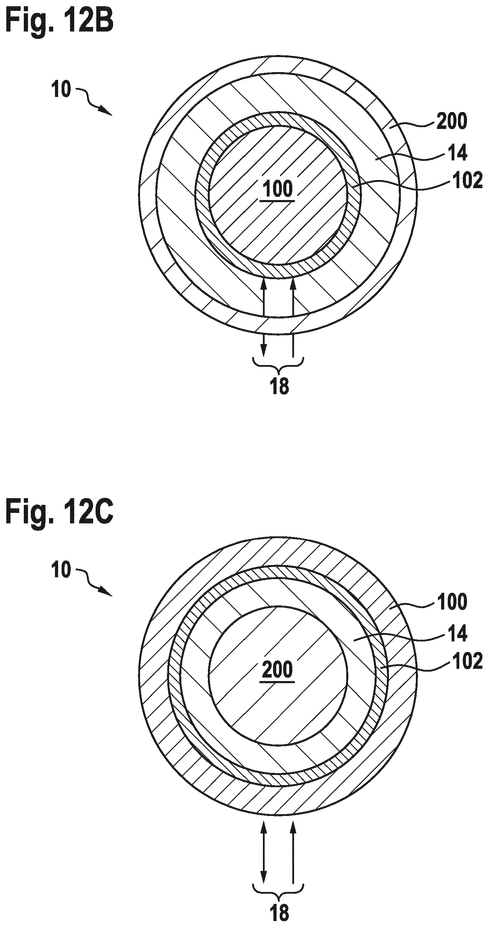

Auch Statoren mit gekrümmten Oberflächen, wie in **Figur 12A** dargestellt können durch entsprechende Anordnung der Magnetgruppen realisiert werden, beispielsweise in runder Bauform, wie in den **Figuren 12B und 12C** dargestellt, welche einen außen- bzw. innengeführten Transportkörper 200 und einen innen- bzw. außenliegenden Stator 100 aufweisen. Beispielsweise können derartige Beförderungsvorrichtungen für eine Verwendung als ein mechanisches Lager vorteilhaft sein, beispielsweise um eine Welle drehbar zu lagern.

Zur Einsparung von Energie können vorzugsweise die Stellelemente 114 vorübergehend mit abgesenktem Strom betrieben oder abgeschaltet werden, solange sich kein Transportkörper 200 im Einzugsbereich der jeweiligen Magnetgruppe 24 befindet. Bei Annäherung eines Transportkörpers 200 werden sie vorzugsweise kurzfristig wieder aktiviert.

Die Außenflächen von Stator 100 und Transportkörper 200 können vorzugsweise so gestaltet werden, dass sie an die jeweiligen Umweltbedingungen angepasst sind, beispielsweise an extreme Temperaturanforderungen, hohe Sauberkeitsanforderungen, Partikelfreiheit, Keimfreiheit, leichte Reinigbarkeit, Beständigkeit gegen aggressive Materialien, Einsatz in explosionsgefährdeten Bereichen, Einsatz unter Flüssigkeits- oder Gasatmosphäre etc. angepasst sind. Dafür steht beispielsweise eine breite Palette von nicht-ferromagnetischen Materialien zur Verfügung, wie etwa Nichteisenmetalle, Kunststoff, Teflon, Keramik, Glas, Gummi, Holz u.v.m.

Eine Gruppe von Transportkörpern 200 kann vorzugsweise gemeinsam eine Aufgabe ausführen. Beispielsweise können mehrere synchronisiert bewegte Transportkörper 200 eine große Last transportieren, die für einen Transportkörper 200 zu schwer ist. Oder mehrere Transportkörper 200 sind beispielsweise über eine passive Stabkinematik und Gelenke miteinander verbunden, so dass die Kinematik als Handhabungsgerät verwendet werden kann.

Nicht alle Freiheitsgrade müssen notwendigerweise levitierend ausgeführt werden, stattdessen können einzelne Freiheitsgrade auch durch eine mechanische Führung realisiert sein.

Zur preiswerten Realisierung eines levitierenden Systems mit großem Transportbereich kann der Stator 100 vorzugsweise mit klassischen Achssystemen oder Fahrzeugen als Bewegungseinrichtung kombiniert werden. Beispielsweise transportiert ein Achssystem oder ein Fahrzeug mit Rädern einen Stator 100 in einem großen Arbeitsbereich, während der Stator 100 seinerseits einen Transportkörper 200 in einem kleinen Arbeitsbereich präzise und schwebend positionieren kann.

Optional befindet sich zwischen Stator 100 und Transportkörper 200 eine Zwischenebene (Partikel-Barriere). Der Transportkörper 200 kann sich dabei vorzugsweise im sauberen Bereich befinden, das Fahrzeug hingegen außerhalb. Die Fortbewegungsfunktion übernimmt beispielsweise primär das Fahrzeug mit seinem klassischen Radantrieb, die Levitationsfunktion und Präzisionspositionierung der Stator 100 mit Transportkörper 200.

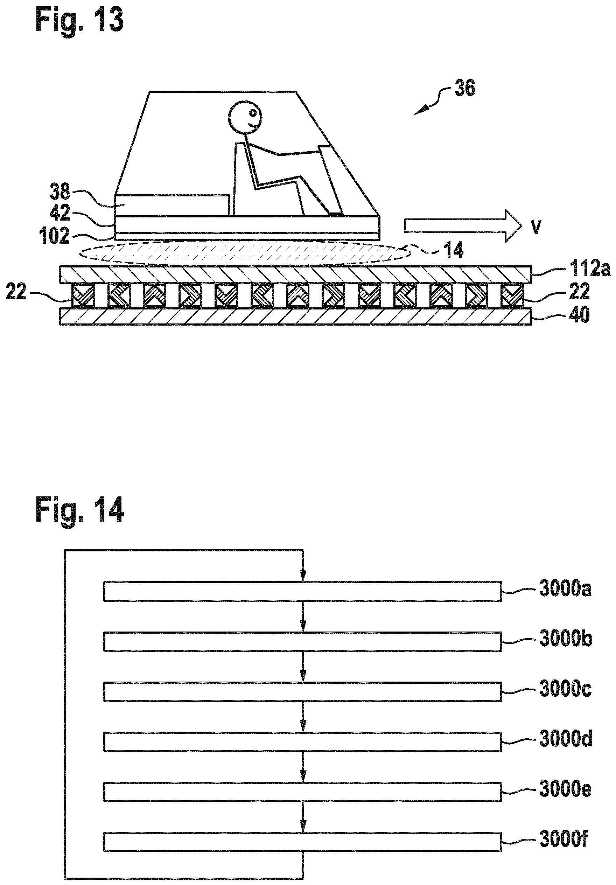

Die Wirkprinzipien von Stator 100 und Transportkörper 200 können in anderen bevorzugten Ausführungsformen vertauscht sein, so dass sich im Stator 100 beispielsweise eine Anordnung von Stationärmagneten 22 befindet und im Transportkörper 200 aktiv bewegliche Stellmagneten 26. Bei dieser Variante kann beispielsweise der Transportkörper 200 die Energieversorgung 38 mitführen (z.B. Akkumulator, Brennstoffzelle, Solarzellen) oder von außen mit Energie versorgt werden (z.B. über ein Kabel). Auf diese Weise kann sich beispielsweise ein Fahrzeug 36 mit aktivem Antrieb ohne Räder fortbewegen, indem es einen Antrieb 42 mit Stellmagneten 26 aufweist, um beispielsweise auf einer am Boden 40 befestigten mit Stationärmagneten 22 bestückten Schiene oder Ebene zu verkehren (siehe **Figur 13).**

Im Folgenden wird auf Basis der zuvor beschriebenen Beförderungsvorrichtung 10 ein Verfahren gemäß einer bevorzugten Ausführungsform beschrieben, mit dem die stabile magnetische Levitation von mindestens einem Transportkörper 200 erreicht wird, ohne dass jedoch die Erfindung auf das erläuterte Verfahren beschränkt ist.

Der mindestens eine Transportkörper 200 erfährt Kräfte und Momente in einem dynamisch veränderlichen Magnetfeld, das durch die geregelte Bewegung von Stellmagneten 26 in mindestens einem Stator 100 erzeugt wird.

Zur Beschreibung der Position des mindestens einen Transportkörpers 200 sind die kartesischen Koordinatensysteme 900 und 920 gegeben:

Jeder Transportkörper i besitzt ein Koordinatensystem $920i$ mit den Achsen $(x_i, y_i, z_i)$ und einem ortsfesten Bezug zum Transportkörper, sein Ursprung liegt beispielsweise in dem berechneten Massenschwerpunkt der Magnetanordnung des Transportkörpers.

Das Stator-Koordinatensystem 900 mit den Achsen $(X, Y, Z)$ hat einen ortsfesten Bezug zum Stator. Seine X- und Y-Achse liegen in der Wirkfläche des Stators, die Z-Achse steht senkrecht auf der Wirkfläche und weist in Richtung des Transportkörpers. Die Position des Transportkörpers mit dem Index i wird im Stator-Koordinatensystem durch den Ortsvektor $\vec{r_i}$ beschrieben, der den Ursprung des Transportkörper-Koordinatensystems angibt. Die Winkellage des Transportkörpers i wird durch den Vektor $\vec{\varphi_i}$ ausgedrückt, dessen drei Komponenten die Winkel angeben, die jeweils von den X-, Y- und Z-Achsen der Koordinatensysteme von Stator und Transportkörper eingeschlossen werden.

Gegeben ist weiterhin eine Anordnung von Magnetgruppen im Stator, die einzeln in mindestens einer Dimension relativ zum Stator beweglich sind und deren Position mit Stellelementen verändert werden kann. Im Folgenden wird davon ausgegangen, dass die Drehlage bzw. Winkellage der Magnetgruppe veränderlich ist, wobei die Drehachse im Stator-Koordinatensystem konstant ist und durch den Massenschwerpunkt der Magnetgruppe verläuft. Die aktuelle Drehlage der Magnetgruppe k ist $\alpha_k$. Von der Steuerung wird der Sollwinkel $\alpha_{k,soll}$ vorgegeben, der von dem Regler des Stellelementes schnell und präzise umgesetzt wird, so dass nach kurzer Zeit $\alpha_k = \alpha_{k,soll}$ ist.

Das Verfahren ist gemäß der bevorzugten Ausführungsform als Programm in der Steuerung implementiert und wird zyklisch mit einer Frequenz von 100 - 10.000 Hz durchlaufen. Die Funktionsschritte eines beispielhaften Schleifendurchlaufes, welcher in **Figur 14** beispielhaft dargestellt ist, ist im Folgenden beschrieben.

**3000a) Bestimmung der Ist-Position und der Ist-Geschwindigkeit der Transportkörper**

Magnetfeld-Sensoren, kapazitive Sensoren und/oder optische Sensoren sind in einem regelmäßigen Raster unterhalb der Wirkfläche des Stators angebracht. Die folgende Beschreibung stützt sich beispielhaft auf Hall-Sensoren. Jeder Hall-Sensor misst drei magnetische Feldkomponenten in orthogonalen Richtungen. Die Sensor-Rohwerte werden von einem Rechner eingelesen, ebenso wie die Winkellage aller Magnetgruppen im Stator. Falls weitere Statoren benachbart sind, werden die dort zeitgleich ermittelten Messwerte über einen Datenbus an den Stator übertragen. Der gesamte Einlesevorgang dauert typischerweise 0,1ms - 1ms.

Zunächst werden die Messwerte jedes Sensors um den Einfluss der ihm benachbarten Magnetgruppen korrigiert. Die Feldbeiträge der benachbarten Magnetgruppen wurden für jeden Sensor einmalig in einem Initialisierungslauf bestimmt und sind drehwinkelabhängig in Korrekturtabellen abgelegt. Unter Verwendung der aktuell eingelesenen Drehwinkel der benachbarten Magnetgruppen wird auf die Korrekturtabellen zugegriffen. Von allen Sensor-Rohwerten werden die Feldbeiträge der benachbarten Magnetgruppen subtrahiert. Die so erhaltenen korrigierten Sensorwerte repräsentieren die Flussdichte der Transportkörper-Magnetanordnung über der Wirkfläche.

Danach wird die Position des mindestens einen Transportkörpers ermittelt. Dazu ist im Speicher des Rechners eine Beschreibung der Magnetanordnung der Transportkörper als Liste hinterlegt. Die Liste enthält die Positionen und Dipolvektoren aller Stellmagneten und/oder Magnetgruppen 24, angegeben im Transportkörper-Koordinatensystem. Mit Hilfe dieser Liste, der Feldgleichung für einen magnetischen Dipol und des Superpositionsprinzips wird ein Rechenmodell der Flussdichteverteilung des Transportkörpers erstellt. Mit dem Modell lassen sich die Flussdichtevektoren berechnen, die bei einer vorgegebenen Transportkörper-Position am Ort der Stator-Sensoren zu erwarten sind. Eine skalare Fehlerfunktion ermittelt ein Maß für die Fehlanpassung der gemessenen und modellierten Flussdichten aller Transportkörper und Magnetgruppen. Durch iterative Optimierung der Position und Winkellage der Transportkörper im Modell wird die Fehlerfunktion minimiert, also auf die realen Messdaten angepasst. Das Iterationsverfahren wird beendet, sobald keine Verbesserung mehr erzielt wird und/oder eine zuvor definierte Fehlerschwelle unterschritten wird.

Die so ermittelte 6D-Position des mindestens einen Transportkörpers i wird im Rahmen der Genauigkeit des Modells als reale Position des Transportkörpers i mit dem Ortsvektor $\vec{r}_i$ und dem Winkel-Vektor $\vec{\varphi}_i$ interpretiert. Durch numerische Differenzierung der zyklischen Abfolge von Positionswerten wird die Ist-Geschwindigkeit mit dem Geschwindigkeitsvektor $\vec{v}_{i,soll}$ für die Translation und dem Winkelgeschwindigkeits-Vektor $\vec{\omega}_{i,soll}$ für die Rotation berechnet.

### 3000b) Bestimmung der Soll-Position und Soll-Geschwindigkeit der Transportkörper

Eine übergeordnete Anlage kann der Steuerung die gewünschte Bewegungsbahn des mindestens einen Transportkörpers als Folge von 6D-Soll-Positionen, Soll-Zeiten und/oder Soll-Geschwindigkeiten mitteilen. Die Bahn kann aus Geraden, Kreisabschnitten oder anderen geometrischen Grundelementen bestehen.

Die Steuerung interpoliert die Bewegungsbahn räumlich und zeitlich. Zur räumlichen Interpolation kommen verschiedene Interpolationsverfahren in Betracht, die in der Robotik üblich sind, beispielsweise lineare, Spline- oder Polynom-Interpolation. Zur zeitlichen Interpolation zerlegt die Steuerung die räumlich interpolierte Bahn in Stützpunkte. In jedem Zyklus stellt sie für jeden Transportkörper i die Soll-Position mit dem Ortsvektor $\vec{r}_{i,soll}$ und dem Winkel-Vektor $\vec{\varphi}_{i,soll}$ bereit sowie optional die Soll-Geschwindigkeit mit dem Geschwindigkeitsvektor $\vec{v}_{i,soll}$ für die Translation und dem Winkelgeschwindigkeits-Vektor $\vec{\omega}_{i,soll}$ für die Rotation und übergibt diese an den Bahnregler.

### 3000c) Bahnregelung

Die Bahnregelung dient dazu, die Ist-Position der Transportkörper schnell und präzise auf die Soll-Position nachzuführen. Dazu berechnet der Bahnregler die Regelabweichung, also die Differenz zwischen Soll- und Ist-Position und/oder der Soll- und Ist-Geschwindigkeit in allen 6 Dimensionen. Diese verwendet er als Eingangsgröße für einen Regelalgorithmus, beispielsweise den PID-Algorithmus, der für jede zu regelnde Dimension separat berechnet wird. Als Ausgangsgröße liefert der Bahnregler für jeden Transportkörper i den Soll-Kraftvektor $\vec{F}_{i,soll}$ und den Soll-Momentenvektor $\vec{M}_{i,soll}$ der zur Korrektur der Bahn erforderlich ist. Die Reglerparameter, wie Verstärkung (P), Nachstellzeit (I) und Vorhaltzeit (D), sind entweder einmalig ermittelt und fest in der Steuerung hinterlegt, oder werden dynamisch an den Bewegungs- und Beladungszustand der Transportkörper angepasst, wie beispielsweise an deren Gesamtmasse oder die Massenverteilung, die durch einen Beobachter bzw. eine Beobachtungsvorrichtung (s. 3000f)) ermittelt werden kann.

### 3000d) Kraft-/Momentensteuerung

Aus den Soll-Kraftvektoren und den Soll-Momentvektoren für alle Transportkörper berechnet dieser Programmteil die Sollpositionen für alle Magnetgruppen, die zur Erzeugung der SollKräfte und -Momente führen. Berücksichtigt werden alle Magnetgruppen, die einen Einfluss auf die zu steuernden Transportkörper haben. Dazu verwendet die Kraft-/Momentensteuerung ein räumliches Modell der Magnetanordnung im Stator und in dem mindestens einen Transportkörper. Das Modell ist in der Lage, näherungsweise die Kräfte und Momente zu berechnen, die sich bei vorgegebener Position der Magnetgruppen einstellen. In dem Modell sind die Magnetanordnungen der Transportkörper als Liste der Positionen und Dipolvektoren aller Transportkörper-Magneten hinterlegt. Ebenso ist eine Liste der Magneten jeder Magnetgruppe hinterlegt. In dem Modell werden zunächst die partiellen Kräfte und Momente zwischen allen Magnetpaaren berechnet, daraus wird anschließend die auf jeden Transportkörper wirkende Gesamtkraft und das Gesamtmoment errechnet. Dabei werden alle Einflüsse bestmöglich berücksichtigt, beispielsweise auch die zwischen zwei Transportkörpern gegenseitig ausgeübten Kräfte und Momente.

Zur Berechnung kommen im Wesentlichen folgende Gleichungen zur Anwendung Magnetisches Feld $\vec{B}$ eines magnetischen Dipols $\vec{\mu}$ am Ort $\vec{r}$ :

$$\vec{B}(\vec{r}) = \frac{\mu_0}{4\pi} \frac{3\vec{r}\,(\vec{\mu}\vec{r}) - \vec{\mu}r^2}{r^5}$$

mit $r = r$ , wobei $\mu_0$ die magnetische Feldkonstante ist.
Magnetisches Feld $\vec{B}_{ges}$ als Überlagerung der Felder $\vec{B}_i$ (Superpositionsprinzip)

$$\vec{B}_{ges}(\vec{r}) = \sum_{i=1}^{n} \vec{B}_i(\vec{r})$$

wobei n die Anzahl der sich überlagernden Felder darstellt.
Kraft $\vec{F}$ auf einen magnetischen Dipol $\vec{\mu}$ im Feld B:

$$\vec{F} = \vec{\nabla}(\vec{\mu}\vec{B}).$$

Das Drehmoment $\vec{M}$, das auf einen magnetischen Dipol $\vec{\mu}$ im Feld $\vec{B}$ wirkt:

$$\vec{M} = \vec{\mu} \times \vec{B}$$

Das zusätzliche Drehmoment $\vec{M}_F$ durch Kräfte $\vec{F}_i$, die im Abstand $\vec{r}_i$ vom Schwerpunkt angreifen, wobei n die Anzahl der Kräfte darstellt:

$$\vec{M}_F = \sum_{i=1}^{n} \vec{r}_i \times \vec{F}_i$$

Unter Einbeziehung der Ist-Position aller Stellelemente und Transportkörper wird in dem Modell der Ist-Kraftvektor $\vec{F}_i$ und der Ist-Momentenvektor $\vec{M}_i$ berechnet, der aktuell auf jeden Transportkörper i wirkt. Die Fehlanpassung zwischen den Ist- und Soll-Kräften sowie den Ist- und Soll-Momenten aller Transportkörper wird durch eine skalare Fehlerfunktion E bewertet:

$$E = \sum_{i=1}^{m} \left( \frac{|\vec{F}_{i,soll} - \vec{F}_i|}{F_0} \right)^2 + \left( \frac{|\vec{M}_{i,soll} - \vec{M}_i|}{M_0} \right)^2$$

wobei m die Anzahl der Transportkörper darstellt, $\vec{F}_i$ bzw. $\vec{M}_i$ die Ist-Kraft bzw. das Ist-Moment, $\vec{F}_{i,soll}$ bzw. $\vec{M}_{i,soll}$ die Soll-Kraft bzw. das Soll-Moment und $F_0$ bzw. $M_0$ die Referenz-Kraft bzw. das Referenz-Moment.
Je kleiner E, desto besser ist die Übereinstimmung zwischen den Ist- und Soll-Kräften und - Momenten aller Transportkörper. Die Fehlerfunktion kann modifiziert oder um zusätzliche Terme erweitert werden, so dass energetisch günstigere Konstellationen bevorzugt werden. So kann das Verhalten des Gesamtsystems beispielsweise optimiert werden auf minimalen Leistungsbedarf, minimale Positionsänderung der Magnetgruppen oder minimale Anzahl von Magnetgruppen, die an einer Positionsänderung beteiligt sind.
In einem iterativen Optimierungsverfahren werden die Positionen der Magnetgruppen in dem Modell schrittweise verändert. Nach jedem Schritt werden die Kräfte und Momente im Modell neu berechnet und durch die Fehlerfunktion bewertet. Schritte, die zur Senkung des Fehlers E führen, werden beibehalten und bilden die Basis für den nächsten Iterationsschritt. Sobald der Fehler nicht weiter gesenkt werden kann und/oder eine voreingestellte Schwelle unterschreitet und/oder eine vorgegebene Anzahl von Iterationsschritten ausgeführt wurde, wird die Optimierungsschleife beendet.

### 3000e) Ausgabe der Soll-Positionen an die Stellelemente

Die im Modell optimierten Positionen der Magnetgruppen werden als Soll-Vorgabe an die Stellelemente ausgegeben.

### 3000f) Beobachter zur Ermittlung der Bewegungsparameter (optional)

Ein als "Beobachter" bezeichneter Algorithmus erfasst den zeitlichen Verlauf der Ist-Position der Magnetgruppen sowie der Transportkörper als Reaktion darauf. Er nutzt diese Informationen, um mit Hilfe eines erweiterten Modells die Bewegungsparameter der Transportkörper zu bestimmen. Das erweiterte Modell basiert auf dem zuvor beschriebenen Kraft-/Momenten-Modell und wird um weitere physikalische Größen ergänzt, die den Bewegungszustand des Transportkörpers beschreiben, beispielsweise Masse, Dämpfung, Schwerpunkt, Schwerkraftvektor, Trägheitstensor oder Inertialbeschleunigung. Zusätzlich werden im Modell die Bewegungsgleichungen der Transportkörper berechnet, sowohl in Translation als auch in Rotation.
Da die Bewegungsparameter a priori nicht bekannt sind, wird ihr Wert zu Beginn geschätzt und anschließend in einer iterativen Berechnung des Modells durch gezielte Parametervariation optimiert. Zur Bewertung der Fehlanpassung wird eine skalare Fehlerfunktion verwendet, welche die Abweichung der modellierten Bahnkurve von der gemessenen Bahnkurve über den Zeitraum der letzten Messungen bewertet.

Als Ergebnis stehen Näherungswerte für die oben genannten Bewegungsparameter zur Verfügung. Diese können z.B. innerhalb der Steuerung zur Optimierung der Reglerparameter wie P, I und D verwendet werden. Beispielsweise kann das Gesamtgewicht m des Transportkörpers mit Zuladung ermittelt werden und in der Bahnregelung als Faktor in die Berechnung der Sollkräfte und -momente eingehen, so dass bei doppeltem Gewicht die doppelten Kräfte und Momente an den Transportkörper ausgegeben werden und somit die Beschleunigung a = F/m unabhängig von der Masse ist. Die Bewegungsparameter können auch als Zustandsinformation an die übergeordnete Anlage ausgegeben werden (Abb. 16), so dass diese beispielsweise aus dem Gewicht des Transportkörpers auf den Beladungszustand schließen und dadurch eine Prozesskontrolle durchführen kann. Beispielsweise kann die Beförderungsvorrichtung zur Erkennung eines Beladungszustands bzw. der Gesamtmasse des Transportkörpers eine Beladungserkennungsvorrichtung aufweisen. In einem anderen Beispiel kann eine Schwerpunktverlagerung, beispielsweise beim Transport einer schwappenden Flüssigkeit, aktiv ausgeregelt werden, so dass offene Behälter mit Flüssigkeit schnell und prozesssicher transportiert werden können.

**Patentansprüche**

1. Beförderungsvorrichtung (10) mit einem Stator (100) und zumindest einem Transportkörper (200), wobei die Beförderungsvorrichtung (10) dazu eingerichtet ist, den zumindest einen Transportkörper (200) in kontrollierter Weise relativ zum Stator (100) zu befördern, wobei:

- der Stator mehrere beweglich angeordnete Stellmagneten (26) aufweist, von denen jeder über ein Stellelement (114) mit dem Stator (100) verbunden ist, wobei das Stellelement (114) dazu eingerichtet ist, eine Orientierung des damit verbundenen Stellmagneten (26) relativ zum Stator (100) in kontrollierter Weise zu ändern;
- der zumindest eine Transportkörper (200) zumindest zwei Stationärmagneten (22) aufweist, welche mit dem Transportkörper (200) derart verbunden sind, dass die zumindest zwei Stationärmagneten (22) relativ zum Transportkörper (200) unbeweglich sind;
- der Stator (100) und der zumindest eine Transportkörper (200) mittels der zumindest zwei Stationärmagneten (22) und der mehreren Stellmagneten (26) magnetisch gekoppelt sind; und

- die Beförderungsvorrichtung (10) dazu eingerichtet ist, den zumindest einen Transportkörper (200) durch eine kontrollierte Orientierung der mehreren Stellmagneten (26) mittels der Stellelemente (114) relativ zum Stator (100) zu befördern, wobei die mehreren Stellmagneten (26) jeweils zumindest einen Permanentmagneten aufweisen.

2. Beförderungsvorrichtung (10) mit einem Stator (100) und zumindest einem Transportkörper (200), wobei die Beförderungsvorrichtung (10) dazu eingerichtet ist, den zumindest einen Transportkörper (200) in kontrollierter Weise relativ zum Stator (100) zu befördern, wobei:

- der zumindest eine Transportkörper (200) mehrere beweglich angeordnete Stellmagneten (26) aufweist, von denen jeder über ein Stellelement (114) mit dem Transportkörper (200) verbunden ist, wobei das Stellelement (114) dazu eingerichtet ist, eine Orientierung des damit verbundenen Stellmagneten (26) relativ zum Transportkörper (200) in kontrollierter Weise zu ändern;
- der Stator (100) zumindest zwei Stationärmagneten (22) aufweist, welche mit dem Stator (100) derart verbunden sind, dass die zumindest zwei Stationärmagneten (22) relativ zum Stator (100) unbeweglich sind;
- der zumindest eine Transportkörper (200) und der Stator (100) mittels der zumindest zwei Stationärmagneten (22) und der mehreren Stellmagneten (26) magnetisch gekoppelt sind; und
- die Beförderungsvorrichtung (10) dazu eingerichtet ist, den zumindest einen Transportkörper (200) durch eine kontrollierte Orientierung der mehreren Stellmagneten (26) mittels des Stellelements (114) relativ zum Stator (100) zu befördern, **dadurch gekennzeichnet, dass** die mehreren Stellmagneten (26) jeweils zumindest einen Permanentmagneten aufweisen.

3. Beförderungsvorrichtung (10) nach einem der vorhergehenden Ansprüche, wobei das Stellelement (114) dazu eingerichtet ist, eine Position des damit verbundenen Stellmagneten (26) relativ zum Stator (100) in kontrollierter Weise zu ändern, so dass die Beförderungsvorrichtung (10) dazu eingerichtet ist, den zumindest einen Transportkörper (200) auch durch eine kontrollierte Positionierung der mehreren Stellmagneten (26) mittels der Stellelemente (114) relativ zum Stator (100) zu befördern.

4. Beförderungsvorrichtung (10) nach einem der vorhergehenden Ansprüche, wobei die zumindest zwei Stationärmagneten (22)

- zwei Stationärmagneten (22), welche auf einer Geraden angeordnet sind, wobei ein Dipolmoment mindestens eines der Stationärmagneten nicht parallel zu dieser Geraden orientiert ist, oder

- drei oder mehr Stationärmagneten (22)

aufweisen.

5. Beförderungsvorrichtung (10) nach einem der vorhergehenden Ansprüche, wobei die mehreren Stellmagneten (26) und/oder die zumindest zwei Stationärmagneten (22) einer Beförderungsfläche zugewandt angeordnet sind, wobei die Beförderungsvorrichtung (10) dazu eingerichtet ist, den zumindest einen Transportkörper (200) entlang der Beförderungsfläche in kontrollierter Weise relativ zum Stator (100) zu befördern.

6. Beförderungsvorrichtung (10) nach einem der vorhergehenden Ansprüche, wobei die zumindest zwei Stationärmagneten (22) jeweils zumindest einen Permanentmagneten aufweisen.

7. Beförderungsvorrichtung (10) nach einem der vorhergehenden Ansprüche, wobei der zumindest eine Permanentmagnet eine magnetische Flussdichte von zumindest 0,05 T, bevorzugt zumindest 0,1 T, weiter bevorzugt zumindest 0,25 T, noch weiter bevorzugt zumindest 0,5 T, besonders bevorzugt zumindest 0,75 T, am meisten bevorzugt zumindest 1 T besitzt.

8. Beförderungsvorrichtung (10) nach einem der vorhergehenden Ansprüche, wobei die mehreren Stellmagneten (26) jeweils eine Magnetgruppe (24) aufweisen und/oder die zumindest zwei Stationärmagneten (22) in einer Magnetgruppe (24) angeordnet sind, wobei vorzugsweise jeder Stellmagnet (26) eine Magnetgruppe (24) aufweist und/oder wobei vorzugsweise jeder Stellmagnet (26) eine Magnetgruppe (24) aufweist, und wobei jede Magnetgruppe einer Mehrzahl von Permanentmagneten und/oder Magnetspulen aufweist.

9. Beförderungsvorrichtung (10) nach Anspruch 8, wobei die Mehrzahl von Permanentmagneten und/oder Magnetspulen der zumindest einen Magnetgruppe (24) gemäß zumindest einem Halbach-Array derart angeordnet sind, dass sich ein Magnetfeld der Magnetgruppe (24) vorzugsweise zur Beförderungsfläche hin erstreckt.

10. Beförderungsvorrichtung (10) nach einem der vorhergehenden Ansprüche, wobei das Stellelement (114) ein Antriebselement aufweist, welches dazu eingerichtet ist, die Orientierung und vorzugsweise auch die Position des damit verbundenen Stellmagneten (26) in kontrollierter Weise zu ändern; und/oder wobei das Stellelement (114) ein Sensorelement aufweist, welches dazu eingerichtet ist, die Orientierung und vorzugsweise auch die Position des mit dem Stellelement (114) verbundenen Stellmagneten (26) zu ermitteln; und/oder wobei das Stellelement (114) ein Kontrollelement aufweist, welches dazu eingerichtet ist, die Orientierung und vorzugsweise auch die Position des mit dem Stellelement (114) verbundenen Stellmagneten (26) mittels des Antriebs auf einen vorbestimmten Wert einzustellen.

11. Beförderungsvorrichtung (10) nach einem der vorhergehenden Ansprüche, wobei die Beförderungsvorrichtung (10) dazu eingerichtet ist, den zumindest einen Transportkörper (200) mittels der mehreren Stellmagneten (26) und der zumindest zwei Stationärmagneten (22) relativ zum Stator (100) zu levitieren.

12. Beförderungsvorrichtung (10) nach einem der vorhergehenden Ansprüche, ferner aufweisend eine Positionsbestimmungseinheit, welche dazu eingerichtet ist, eine relative Position und/oder Orientierung des zumindest einen Transportkörpers (200) relativ zum Stator (100) zu ermitteln.

13. Beförderungsvorrichtung (10) nach einem der vorhergehenden Ansprüche, ferner aufweisend eine Bewegungseinrichtung, welche dazu eingerichtet ist, den Stator relativ zu einer Umgebung zu bewegen.

14. Beförderungsvorrichtung (10) nach einem der vorhergehenden Ansprüche, wobei der Transportkörper (200) oder der Stator einen Energiespeicher aufweist und vorzugsweise als ein Fahrzeug ausgebildet ist.

15. Beförderungsvorrichtung (10) nach einem der vorhergehenden Ansprüche, wobei der zumindest eine Transportkörper (200) zumindest einen internen Freiheitsgrad aufweist und vorzugsweise insgesamt mehr als sechs Freiheitsgrade aufweist.

16. Beförderungsvorrichtung (10) nach einem der vorhergehenden Ansprüche, wobei der Stator (100) und/oder der Transportkörper (200) ferner eine Abdeckung (112a) aufweisen, welche dazu eingerichtet ist, zwischen dem Stator (100) und dem Transportkörper (200) wirkende Kräfte zu begrenzen.

17. Beförderungsvorrichtung (10) nach einem der vorhergehenden Ansprüche, wobei die Stationärmagneten (22) als zweidimensionale Halbach-Arrays angeordnet sind und insbesondere eine rechteckige und/oder quadratische und/oder hexagonale und/oder kreisförmige Anordnung aufweisen.

18. Beförderungsvorrichtung (10) nach einem der vorhergehenden Ansprüche, wobei die Stationärmagneten (22) im Transportkörper (200) zumindest teilweise zylinderförmig und/oder kugelförmig derart angeordnet sind, dass diese einen größeren Schwenkbereich aufweisen als Transportkörper (200) mit einer ebenen Anordnung von Stationärmagneten (22).

19. Beförderungsvorrichtung (10) nach einem der vorhergehenden Ansprüche, wobei der zumindest eine Transportkörper (200) ein Identifikationselement aufweist und die Beförderungsvorrichtung (10) dazu eingerichtet ist, den Transportkörper (200) anhand des Identifikationselements zu identifizieren.

20. Beförderungsvorrichtung (10) nach einem der vorhergehenden Ansprüche, wobei der Stator mehrere Stator-Module aufweist, welche vorzugsweise aneinander angrenzend angeordnet sind.

21. Beförderungsvorrichtung (10) nach einem der vorhergehenden Ansprüche, wobei die Stellelemente (114) als Drehsteller ausgebildet sind, welche insbesondere eine Drehachse senkrecht zu einer Wirkfläche (102) des Stators (100) aufweisen.

22. Beförderungsvorrichtung (10) nach einem der vorhergehenden Ansprüche, wobei der Stator (100) eine gekrümmte Wirkfläche (102) aufweist.

23. Beförderungsvorrichtung (10) nach einem der vorhergehenden Ansprüche, wobei eine Anzahl von Freiheitsgraden der Stellmagneten (26) zumindest so groß ist wie eine Anzahl von Freiheitsgraden, entlang welcher der zumindest eine Transportkörpers (200) in kontrollierter Weise befördert und/oder positioniert werden soll.

24. Beförderungsvorrichtung (10) nach einem der vorhergehenden Ansprüche, wobei die Beförderungsvorrichtung (10) als ein berührungsloses mechanisches Lager ausgebildet ist.

25. Beförderungsvorrichtung (10) nach einem der vorhergehenden Ansprüche, wobei die Beförderungsvorrichtung dazu eingerichtet ist, im Falle einer Unterbrechung einer Leistungsversorgung den zumindest eine Transportkörper an dem zumindest einen Stator zu fixieren.

26. Beförderungsvorrichtung (10) nach einem der vorhergehenden Ansprüche, ferner umfassend eine Beladungserkennungsvorrichtung, welche dazu eingerichtet ist, einen Beladungszustand des Transportkörpers zu ermitteln.

27. Beförderungsvorrichtung (10) nach einem der vorhergehenden Ansprüche, ferner umfassend eine Beobachtungsvorrichtung, welche dazu eingerichtet ist, eine Masse und/oder einen Schwerpunkt des Transportkörpers (200) relativ zum Stator (100) zu ermitteln.

28. Verfahren zum Betrieb einer Beförderungsvorrichtung (10) nach einem der vorstehenden Ansprüche, wobei die Stellelemente (114) so angesteuert werden, dass der zumindest eine Transportkörper (200) eine gewünschte Position und/oder Orientierung relativ zum Stator (100) einnimmt.

29. Verfahren nach Anspruch 27, wobei die gewünschte Position und/oder Orientierung sechs Freiheitsgrade hat.

30. Verfahren nach Anspruch 28 oder 29, wobei der Schritt des Ansteuerns der Stellelemente (114) so, dass der zumindest eine Transportkörper (200) eine gewünschte Position und/oder Orientierung relativ zum Stator (100) einnimmt, umfasst:

     - Bestimmen einer Ist-Position und/oder einer Ist-Geschwindigkeit des Transportkörpers (200) relativ zum Stator (100);
     - Bestimmen einer Soll-Position und/oder einer Soll-Geschwindigkeit des Transportkörpers (200) relativ zum Stator (100);
     - Ermitteln einer Abweichung der Ist-Position und/oder der Ist-Geschwindigkeit von der Soll-Position bzw. der Soll-Geschwindigkeit;
     - Berechnen von Soll-Stellungen zumindest eines Teils der Stellmagneten (26) derart, dass die jeweiligen Stellmagneten (26) auf eine Verringerung der Abweichung der Soll-Position und/oder der Soll-Geschwindigkeit von der Ist-Position bzw. der Ist-Geschwindigkeit des Transportkörpers hinwirken.
     - Anordnen der jeweiligen Stellmagneten (26) mittels der Stellelemente (114) derart, dass die jeweiligen Stellmagneten die Soll-Stellungen einnehmen.

**Claims**

1. Conveying device (10) with a stator (100) and at least one transport body (200), wherein the conveying device (10) is configured to convey the at least one transport body (200) relative to the stator (100) in controlled fashion, wherein:

     - the stator comprises several movably arranged actuating magnets (26), each of which is connected to the stator (100) via an actuating element (114), wherein the actuating element (114) is configured to change an orientation of the connected actuating magnet (26) relative to the stator (100) in controlled fashion;
- the at least one transport body (200) comprises at least two stationary magnets (22) which are connected to the transport body (200) such that the at least two stationary magnets (22) are immovable relative to the transport body (200);
- the stator (100) and the at least one transport body (200) are magnetically coupled by means of the at least two stationary magnets (22) and the several actuating magnets (26); and
- the conveying device (10) is configured to convey the at least one transport body (200) relative to the stator (100) by controlled orientation of the several actuating magnets (26) by means of the actuating elements (114), wherein the several actuating magnets (26) each comprise at least one permanent magnet.

2. Conveying device (10) with a stator (100) and at least one transport body (200), wherein the conveying device (10) is configured to convey the at least one transport body (200) relative to the stator (100) in controlled fashion, wherein:

- the at least one transport body (200) comprises several movably arranged actuating magnets (26), each of which is connected to the transport body (200) via an actuating element (114), wherein the actuating element (114) is configured to change an orientation of the connected actuating magnet (26) relative to the transport body (200) in controlled fashion;
- the stator (100) comprises at least two stationary magnets (22) which are connected to the stator (100) such that the at least two stationary magnets (22) are immovable relative to the stator (100);
- the at least one transport body (200) and the stator (100) are magnetically coupled by means of the at least two stationary magnets (22) and the several actuating magnets (26); and
- the conveying device (10) is configured to convey the at least one transport body (200) relative to the stator (100) by controlled orientation of the several actuating magnets (26) by means of the actuating element (114), **characterized in that** the several actuating magnets (26) each comprise at least one permanent magnet.

3. Conveying device (10) according to either of the preceding claims, wherein the actuating element (114) is configured to change a position of the connected actuating magnet (26) relative to the stator (100) in controlled fashion, so that the conveying device (10) is configured to also convey the at least one transport body (200) relative to the stator (100) by controlled positioning of the several actuating magnets (26) by means of the actuating elements (114).

4. Conveying device (10) according to any of the preceding claims, wherein the at least two stationary magnets (22) comprise

- two stationary magnets (22) which are arranged on a straight line, wherein a dipole moment of at least one of the stationary magnets is not oriented parallel to this straight line, or
- three or more stationary magnets (22).

5. Conveying device (10) according to any of the preceding claims, wherein the several actuating magnets (26) and/or the at least two stationary magnets (22) are arranged facing a conveying surface, wherein the conveying device (10) is configured to convey the at least one transport body (200) relative to the stator (100) along the conveying surface in controlled fashion.

6. Conveying device (10) according to any of the preceding claims, wherein the at least two stationary magnets (22) each comprise at least one permanent magnet.

7. Conveying device (10) according to any of the preceding claims, wherein the at least one permanent magnet has a magnetic flux density of at least 0.05 T, preferably at least 0.1 T, further preferably at least 0.25 T, even further preferably at least 0.5 T, particularly preferably at least 0.75 T, most preferably at least 1 T.

8. Conveying device (10) according to any of the preceding claims, wherein the several actuating magnets (26) each comprise a magnet group (24), and/or the at least two stationary magnets (22) are arranged in a magnet group (24), wherein preferably each actuating magnet (26) comprises a magnet group (24), and/or wherein preferably each actuating magnet (26) comprises a magnet group (24), and wherein each magnet group comprises a plurality of permanent magnets and/or magnetic coils.

9. Conveying device (10) according to Claim 8, wherein the plurality of permanent magnets and/or magnetic coils of the at least one magnet group (24) are arranged according to at least one Halbach array such that a magnetic field of the magnet group (24) preferably extends towards the conveying surface.

10. Conveying device (10) according to any of the preceding claims, wherein the actuating element (114) comprises a drive element which is configured to change the orientation and preferably also the position of the connected actuating magnet (26) in controlled fashion; and/or wherein the actuating element (114) comprises a sensor element which is configured to determine the orientation and preferably also the position of the actuating magnet (26) connected to the actuating element (114); and/or wherein the actuating element (114) comprises a control element which is configured to adjust the orientation and preferably also the position of the actuating magnet (26) connected to the actuating element (114) to a predefined value by means of the drive.

11. Conveying device (10) according to any of the preceding claims, wherein the conveying device (10) is configured to levitate the at least one transport body (200) relative to the stator (100) by means of the several actuating magnets (26) and the at least two stationary magnets (22).

12. Conveying device (10) according to any of the preceding claims, further comprising a position determination unit which is configured to determine a relative position and/or orientation of the at least one transport body (200) relative to the stator (100).

13. Conveying device (10) according to any of the preceding claims, further comprising a movement device which is configured to move the stator relative to an environment.

14. Conveying device (10) according to any of the preceding claims, wherein the transport body (200) or the stator comprises an energy store and is preferably configured as a vehicle.

15. Conveying device (10) according to any of the preceding claims, wherein the at least one transport body (200) has at least one internal degree of freedom, and preferably in total more than six degrees of freedom.

16. Conveying device (10) according to any of the preceding claims, wherein the stator (100) and/or the transport body (200) furthermore comprise a cover (112a) which is configured to limit the forces acting between the stator (100) and the transport body (200).

17. Conveying device (10) according to any of the preceding claims, wherein the stationary magnets (22) are arranged as two-dimensional Halbach arrays and in particular have a rectangular and/or square and/or hexagonal and/or circular arrangement.

18. Conveying device (10) according to any of the preceding claims, wherein the stationary magnets (22) in the transport body (200) are arranged at least partially in the form of a cylinder and/or ball, such that they have a greater pivot range than transport bodies (200) with a flat arrangement of stationary magnets (22).

19. Conveying device (10) according to any of the preceding claims, wherein the at least one transport body (200) has an identification element, and the conveying device (10) is configured to identify the transport body (200) from the identification element.

20. Conveying device (10) according to any of the preceding claims, wherein the stator comprises several stator modules which are preferably arranged adjacent to each other.

21. Conveying device (10) according to any of the preceding claims, wherein the actuating elements (114) are configured as rotary actuators which in particular have a rotation axis perpendicular to an action surface (102) of the stator (100).

22. Conveying device (10) according to any of the preceding claims, wherein the stator (100) has a curved action surface (102).

23. Conveying device (10) according to any of the preceding claims, wherein a number of degrees of freedom of the actuating magnets (26) is at least as great as a number of degrees of freedom along which the at least one transport body (200) is to be conveyed and/or positioned in controlled fashion.

24. Conveying device (10) according to any of the preceding claims, wherein the conveying device (10) is configured as a contactless mechanical bearing.

25. Conveying device (10) according to any of the preceding claims, wherein the conveying device is configured to fix the at least one transport body to the at least one stator in the event of an interruption in the power supply.

26. Conveying device (10) according to any of the preceding claims, further comprising a load detection device which is configured to determine a load state of the transport body.

27. Conveying device (10) according to any of the preceding claims, further comprising an observation device which is configured to determine a mass and/or a centre of gravity of the transport body (200) relative to the stator (100).

28. Method for operating a conveying device (10) according to any of the preceding claims, wherein the actuating elements (114) are actuated such that the at least one transport body (200) assumes a desired position and/or orientation relative to the stator (100).

**29.** Method according to Claim 27, wherein the desired position and/or orientation has six degrees of freedom.

**30.** Method according to Claim 28 or 29, wherein the step of actuating the actuating elements (114) such that the at least one transport body (200) assumes a desired position and/or orientation relative to the stator (100) comprises:

- determining an actual position and/or actual speed of the transport body (200) relative to the stator (100);
- determining a nominal position and/or a nominal speed of the transport body (200) relative to the stator (100);
- establishing a deviation of the actual position and/or actual speed from the nominal position and/or nominal speed;
- calculating nominal settings of at least some of the actuating magnets (26) such that the respective actuating magnets (26) act towards a reduction of the deviation of the nominal position and/or nominal speed from the actual position and/or actual speed of the transport body;
- arranging the respective actuating magnets (26) by means of the actuating elements (114) such that the respective actuating magnets assume the nominal settings.

**Revendications**

**1.** Dispositif de transport (10) comprenant un stator (100) et au moins un corps de transport (200), le dispositif de transport (10) étant conçu pour déplacer ledit au moins un corps de transport (200) de manière contrôlée par rapport au stator (100), dans lequel :

- le stator comporte de multiples aimants de régulation (26) montés mobiles, chacun d'eux étant relié au stator (100) par l'intermédiaire d'un élément de régulation (114), l'élément de régulation (114) étant conçu pour modifier, de manière contrôlée, une orientation de l'aimant de régulation (26) auquel il est lié par rapport au stator (100) ;
- ledit au moins un corps de transport (200) comporte au moins deux aimants fixes (22) qui sont reliés au corps de transport (200) de telle manière que lesdits au moins deux aimants fixes (22) soient immobiles par rapport au corps de transport (200) ;
- le stator (100) et ledit au moins un corps de transport (200) sont accouplés par aimantation au moyen desdits au moins deux aimants fixes (22) et des multiples aimants de régulation (26) ;

et
- le dispositif de transport (10) est conçu pour déplacer ledit au moins un corps de transport (200) par rapport au stator (100) par une orientation contrôlée des multiples aimants de régulation (26) au moyen de l'élément de régulation (114), les multiples aimants de régulation (26) comportant respectivement au moins un aimant permanent.

**2.** Dispositif de transport (10) comprenant un stator (100) et au moins un corps de transport (200), le dispositif de transport (10) étant conçu pour déplacer ledit au moins un corps de transport (200) de manière contrôlée par rapport au stator (100), dans lequel :

- ledit au moins un corps de transport (200) comporte de multiples aimants de régulation (26) montés mobiles, chacun d'eux étant relié au corps de transport (200) par l'intermédiaire d'un élément de régulation (114), l'élément de régulation (114) étant conçu pour modifier, de manière contrôlée, une orientation de l'aimant de régulation (26) auquel il est lié par rapport au corps de transport (200) ;
- le stator (100) comporte au moins deux aimants fixes (22) qui sont reliés au stator (100) de telle manière que lesdits au moins deux aimants fixes (22) soient immobiles par rapport au stator (100) ;
- ledit au moins un corps de transport (200) et le stator (100) sont accouplés par aimantation au moyen desdits au moins deux aimants fixes (22) et des multiples aimants de régulation (26) ; et
- le dispositif de transport (10) est conçu pour déplacer ledit au moins un corps de transport (200) par rapport au stator (100) par une orientation contrôlée des multiples aimants de régulation (26) au moyen de l'élément de régulation (114), **caractérisé en ce que** les multiples aimants de régulation (26) comportent respectivement au moins un aimant permanent.

**3.** Dispositif de transport (10) selon l'une des revendications précédentes, dans lequel l'élément de régulation (114) est conçu pour modifier, de manière contrôlée, une position de l'aimant de régulation (26) auquel il est lié par rapport au stator (100), de sorte que le dispositif de transport (10) est également conçu pour déplacer ledit au moins un corps de transport (200) par rapport au stator (100) par un positionnement contrôlé des multiples aimants de régulation (26) au moyen des éléments de régulation (114).

**4.** Dispositif de transport (10) selon l'une des revendications précédentes, dans lequel lesdits au moins deux aimants fixes (22) comportent :

- deux aimants fixes (22) qui sont agencés sur une ligne droite, un moment dipolaire d'au moins l'un des aimants fixes n'étant pas orienté parallèlement à cette ligne droite, ou
- trois aimants fixes (22) ou plus.

**5.** Dispositif de transport (10) selon l'une des revendications précédentes, dans lequel les multiples aimants de régulation (26) et/ou lesdits au moins deux aimants fixes (22) sont agencés de manière à faire face à une surface de transport, le dispositif de transport (10) étant conçu pour déplacer ledit au moins un corps de transport (200) de manière contrôlée par rapport au stator (100) le long de la surface de transport.

**6.** Dispositif de transport (10) selon l'une des revendications précédentes, dans lequel lesdits au moins deux aimants fixes (22) comportent respectivement au moins un aimant permanent.

**7.** Dispositif de transport (10) selon l'une des revendications précédentes, dans lequel ledit au moins un aimant permanent possède une densité de flux magnétique d'au moins 0,05 T, de préférence d'au moins 0,1 T, plus préférablement d'au moins 0,25 T, encore plus préférablement d'au moins 0,5 T, de manière particulièrement préférable d'au moins 0,75 T, et le plus préférablement d'au moins 1 T.

**8.** Dispositif de transport (10) selon l'une des revendications précédentes, dans lequel les multiples aimants de régulation (26) comportent respectivement un groupe d'aimants (24) et/ou lesdits au moins deux aimants fixes (22) sont agencés dans un groupe d'aimants (24), chaque aimant de régulation (26) comportant de préférence un groupe d'aimants (24) et/ou chaque aimant de régulation (26) comportant de préférence un groupe d'aimants (24), et chaque groupe d'aimants comportant une pluralité d'aimants permanents et/ou de bobines magnétiques.

**9.** Dispositif de transport (10) selon la revendication 8, dans lequel la pluralité d'aimants permanents et/ou de bobines magnétiques dudit au moins un groupe d'aimants (24) sont agencés selon au moins un réseau de Halbach de telle manière qu'un champ magnétique du groupe d'aimants (24) s'étende de préférence vers la surface de transport.

**10.** Dispositif de transport (10) selon l'une des revendications précédentes, dans lequel l'élément de régulation (114) comporte un élément d'entraînement qui est conçu pour modifier de manière contrôlée l'orientation et de préférence également la position de l'aimant de régulation (26) auquel il est lié ; et/ou dans lequel l'élément de régulation (114) comporte un élément capteur qui est conçu pour déterminer l'orientation et de préférence également la position de l'aimant de régulation (26) lié à l'élément de régulation (114) ; et/ou dans lequel l'élément de régulation (114) comporte un élément de contrôle qui est conçu pour régler à une valeur prédéterminée l'orientation et de préférence également la position de l'aimant de régulation (26) lié à l'élément de régulation (114) au moyen de l'entraînement.

**11.** Dispositif de transport (10) selon l'une des revendications précédentes, dans lequel le dispositif de transport (10) est conçu pour faire léviter ledit au moins un corps de transport (200) par rapport au stator (100) au moyen des multiples aimants de régulation (26) et desdits au moins deux aimants fixes (22).

**12.** Dispositif de transport (10) selon l'une des revendications précédentes, comprenant en outre une unité de détermination de position, qui est conçue pour déterminer une position et/ou orientation relative dudit au moins un corps de transport (200) par rapport au stator (100).

**13.** Dispositif de transport (10) selon l'une des revendications précédentes, comprenant en outre un dispositif de déplacement, qui est conçu pour déplacer le stator par rapport à un environnement.

**14.** Dispositif de transport (10) selon l'une des revendications précédentes, dans lequel le corps de transport (200) ou le stator comporte un dispositif de stockage d'énergie et est de préférence conçu sous la forme d'un véhicule.

**15.** Dispositif de transport (10) selon l'une des revendications précédentes, dans lequel ledit au moins un corps de transport (200) présente au moins un degré de liberté interne et présente de préférence au total plus de six degrés de liberté.

**16.** Dispositif de transport (10) selon l'une des revendications précédentes, dans lequel le stator (100) et/ou le corps de transport (200) comportent en outre un capot (112a) qui est conçu pour limiter les forces agissant entre le stator (100) et le corps de transport (200).

**17.** Dispositif de transport (10) selon l'une des revendications précédentes, dans lequel les aimants fixes (22) sont agencés sous la forme de réseaux de Halbach bidimensionnels et présentent en particulier un agencement rectangulaire et/ou carré et/ou hexagonal et/ou circulaire.

**18.** Dispositif de transport (10) selon l'une des revendications précédentes, dans lequel les aimants fixes (22) sont agencés dans le corps de transport (200) au moins partiellement de manière cylindrique et/ou sphérique, de telle sorte qu'ils présentent une plage de pivotement plus grande que les corps de transport (200) avec un agencement plan d'aimants fixes (22).

**19.** Dispositif de transport (10) selon l'une des revendications précédentes, dans lequel ledit au moins un corps de transport (200) comporte un élément d'identification et le dispositif de transport (10) est conçu pour identifier le corps de transport (200) à l'aide de l'élément d'identification.

**20.** Dispositif de transport (10) selon l'une des revendications précédentes, dans lequel le stator comporte de multiples modules de stator, qui sont de préférence agencés de manière adjacente les uns aux autres.

**21.** Dispositif de transport (10) selon l'une des revendications précédentes, dans lequel les éléments de régulation (114) sont conçus sous la forme d'actionneurs rotatifs, lesquels présentent notamment un axe de rotation perpendiculaire à une surface active (102) du stator (100).

**22.** Dispositif de transport (10) selon l'une des revendications précédentes, dans lequel le stator (100) présente une surface active incurvée (102).

**23.** Dispositif de transport (10) selon l'une des revendications précédentes, dans lequel un nombre de degrés de liberté des aimants de régulation (26) est au moins aussi élevé qu'un nombre de degrés de liberté le long desquels ledit au moins un corps de transport (200) doit être déplacé et/ou positionné de manière contrôlée.

**24.** Dispositif de transport (10) selon l'une des revendications précédentes, dans lequel le dispositif de transport (10) est conçu sous la forme d'un palier mécanique sans contact.

**25.** Dispositif de transport (10) selon l'une des revendications précédentes, dans lequel le dispositif de transport est conçu pour fixer ledit au moins un corps de transport audit au moins un stator en cas d'interruption d'une alimentation électrique.

**26.** Dispositif de transport (10) selon l'une des revendications précédentes, comprenant en outre un dispositif de détection de chargement, qui est conçu pour déterminer un état de chargement du corps de transport.

**27.** Dispositif de transport (10) selon l'une des revendications précédentes, comprenant en outre un dispositif d'observation, qui est conçu pour déterminer une masse et/ou un centre de gravité du corps de transport (200) par rapport au stator (100).

**28.** Procédé de fonctionnement d'un dispositif de transport (10) selon l'une des revendications précédentes, dans lequel les éléments de régulation (114) sont commandés de manière à ce que ledit au moins un corps de transport (200) prenne une position et/ou une orientation souhaitée par rapport au stator (100).

**29.** Procédé selon la revendication 27, dans lequel la position et/ou l'orientation souhaitée possède six degrés de liberté.

**30.** Procédé selon la revendication 28 ou 29, dans lequel l'étape de commande des éléments de régulation (114) de manière à ce que ledit au moins un corps de transport (200) prenne une position et/ou une orientation souhaitée par rapport au stator (100) comprend :

    - la détermination d'une position réelle et/ou d'une vitesse réelle du corps de transport (200) par rapport au stator (100) ;
    - la détermination d'une position de consigne et/ou d'une vitesse de consigne du corps de transport (200) par rapport au stator (100) ;
    - la détermination d'un écart de la position réelle et/ou de la vitesse réelle par rapport à la position de consigne ou à la vitesse de consigne ;
    - le calcul de positions de consigne d'au moins une partie des aimants de régulation (26) de telle manière que les aimants de régulation (26) respectifs produisent une réduction de l'écart de la position de consigne et/ou de la vitesse de consigne par rapport à la position réelle ou à la vitesse réelle du corps de transport ;
    - l'agencement des aimants de régulation respectifs (26) au moyen des éléments de régulation (114) de telle manière que les aimants de régulation respectifs prennent les positions de consigne.

## Fig. 1A

## Fig. 6B

**Fig. 1C**

**Fig. 1D**

# Fig. 1E

# Fig. 2A

## Fig. 2B

200

Y1    900

924

Z1 ⊙    → X1

926    922

206

## Fig. 3A

24    22    200

Z1 ⊗    → X1

Y1

22

# Fig. 3B

# Fig. 3C

# Fig. 3D

24    22    200

Z1 ⊗ → X1

Y1

$\lambda \backslash 2$

$\lambda \backslash 2$

# Fig. 3E

24  22    200

Z1 ⊗ → X1

Y1

# Fig. 3F

# Fig. 3G

# Fig. 3H

22    22

24

Z1 ⊗ → X1

↓
Y1    920

# Fig. 3I

22

24

22

Z1 ⊗ → X1

22

↓
Y1    920

22

$\lambda \backslash 2$

EP 3 556 007 B1

# Fig. 3K

# Fig. 3L

## Fig. 3M

## Fig. 4A

# Fig. 4B

# Fig. 4C

# Fig. 5

# Fig. 6A

# Fig. 6B

# Fig. 6C

# Fig. 6D

# Fig. 7A

# Fig. 7B

# Fig. 7C

# Fig. 7D

# Fig. 7E

# Fig. 8A

# Fig. 8B

## Fig. 8C

## Fig. 8D

# Fig. 8E

# Fig. 8F

## Fig. 8G

## Fig. 8H

## Fig. 9A

## Fig. 9B

**Fig. 9C**

**Fig. 10**

# Fig. 11

# Fig. 12A

# Fig. 12B

# Fig. 12C

## Fig. 13

## Fig. 14

**EP 3 556 007 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 8803646 A
- CA 2905783 A
- WO 2015017933 A
- JP H08111313 A
- JP S4913581 Y
- WO 03103995 A2
- DE 19960321 A1